# DEMANDE DE BREVET EUROPEEN

(11) **EP 4 015 446 A1**
(43) Date de publication de la demande: **22.06.2022**
(21) Numéro de dépôt: 21215882.8
(22) Date de dépôt: 20.12.2021
(51) Int. Cl.: B81B 3/00

(54) **MICROSYSTÈME ÉLECTROMÉCANIQUE**

(30) Priorité: 21.12.2020 FR 2013826
(71) Demandeur: Commissariat à l'Energie Atomique et aux Energies Alternatives, 75015 Paris (FR)
(72) Inventeur: MOLLARD, Laurent, 38054 Grenoble Cedex 09 (FR); NICOLAS, Stéphane, 38054 Grenoble Cedex 09 (FR); SAINT-PATRICE, Damien, 38054 Grenoble Cedex 09 (FR)
(74) Mandataire: Bronchart, Quentin

(57) **Abrégé**

L'invention concerne un microsystème électromécanique 1 comprenant au moins deux transducteurs électromécaniques 11 et 11a, une membrane déformable 12 et une cavité 13 contenant hermétiquement un milieu déformable 14 conservant un volume constant sous l'action d'un changement de pression externe. La membrane déformable forme une paroi de la cavité et présente au moins une zone libre 121 de se déformer. Les transducteurs électromécaniques sont configurés de sorte que leur mouvement soit fonction dudit changement de pression externe, et inversement, et soit orienté dans un même sens pour au moins deux d'entre eux. Le microsystème électromécanique 1 est ainsi apte à déformer la zone libre de la membrane pas à pas vers l'intérieur ou vers l'extérieur de la cavité.

## Description

### DOMAINE TECHNIQUE

La présente invention concerne le domaine des microsystèmes électromécaniques. Elle trouve par exemple pour application particulièrement avantageuse l'actionnement ou le déplacement d'objets, y compris sur des distances relativement grandes. L'invention trouve également pour application le domaine de la détection par contact. Elle pourra ainsi être mise en œuvre pour réaliser des capteurs.

### ÉTAT DE LA TECHNIQUE

Dans des applications variées, on peut avoir besoin de déplacer des objets microscopiques, voire nanoscopiques, et/ou avoir besoin de capter des mouvements de tels objets. Il existe des microsystèmes qui permettent cela.

Lorsque ces microsystèmes sont des actionneurs, leurs performances sont évaluées notamment sur les paramètres suivants: l'amplitude du déplacement, la force déployée et la précision du déplacement généré. Lorsque ces microsystèmes sont des capteurs, leurs performances sont évaluées notamment sur les paramètres suivants: la capacité à capter un mouvement sur une amplitude importante et la précision de la mesure.

Par ailleurs, que les microsystèmes soient des actionneurs ou des capteurs, on recherche à ce qu'ils offrent de bonnes performances en termes d'encombrement, de consommation énergétique et de capacité à travailler en fréquence.

Toutes les solutions connues présentent des performances faibles pour l'un au moins de ces paramètres. Généralement, les microsystèmes existants présentent des performances trop peu satisfaisantes pour une combinaison de ces paramètres.

Un objet de la présente invention est de proposer un microsystème électromécanique qui présente des performances améliorées par rapport aux solutions existantes, au moins pour l'un des paramètres mentionnés ci-dessus, ou qui présente un meilleur compromis concernant au moins deux des paramètres susmentionnés.

Un autre objet de la présente invention est de proposer un microsystème électromécanique qui permet de déplacer pas à pas, au moins vers le haut ou vers le bas, un organe externe qui lui est associé ou qui permet de capter un déplacement, au moins vers le haut ou vers le bas, d'un organe externe qui lui est associé.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre au moins l'un des objectifs susmentionnés, selon un mode de réalisation, on prévoit un microsystème électromécanique comprenant :
- au moins deux transducteurs électromécaniques comprenant chacun au moins une partie mobile entre une position d'équilibre, hors sollicitation, et une position hors équilibre, sous sollicitation,
- une membrane déformable,
- une cavité déformable délimitée par des parois.

Au moins une partie de la membrane déformable forme au moins une partie d'une première paroi prises parmi lesdites parois de la cavité.

La cavité est configurée pour contenir hermétiquement un milieu déformable propre à conserver un volume sensiblement constant sous l'action d'un changement de pression externe exercée sur le milieu déformable à travers l'une des parois de la cavité.

La partie mobile de chaque transducteur électromécanique est configurée de sorte que son mouvement soit fonction dudit changement de pression externe ou inversement que son mouvement induise un changement de pression externe. Au moins une partie de la membrane déformable présente au moins une zone libre de se déformer, de préférence de façon élastique, en fonction dudit changement de pression externe.

Les parties mobiles des deux transducteurs électromécaniques sont configurées de sorte que :
- leur sollicitation ou une augmentation de pression externe induise leur mouvement vers l'extérieur de la cavité, ou
- leur sollicitation ou une diminution de pression externe induise leur mouvement vers l'intérieur de la cavité.

Selon un mode de réalisation optionnel, le microsystème électromécanique comprend au moins trois transducteurs électromécaniques comprenant chacun une partie mobile entre une position d'équilibre, hors sollicitation, et une position hors équilibre, sous sollicitation :
- la partie mobile d'un premier transducteur électromécanique est configurée de sorte que sa sollicitation ou une augmentation de pression externe induise son mouvement vers l'extérieur de la cavité,
- la partie mobile d'un deuxième transducteur électromécanique est configurée de sorte que sa sollicitation ou une diminution de pression externe induise son mouvement vers l'intérieur de la cavité, et
- la partie mobile d'un troisième transducteur électromécanique est configurée de sorte que sa sollicitation ou une augmentation de pression externe induise son mouvement vers l'extérieur et/ou vers l'intérieur de la cavité.

Selon un exemple, la zone libre est configurée pour coopérer avec au moins un organe externe de sorte que sa déformation induise, ou soit induite par, un mouvement de l'organe externe.

La solution proposée est ainsi apte à déplacer pas à pas un organe externe, vers l'intérieur ou vers l'extérieur de la cavité, et/ou à capter un mouvement de cet organe, vers l'intérieur ou vers l'extérieur de la cavité.

La sollicitation d'au moins un, voire de chaque, transducteur électromécanique est telle que sa partie mobile passe de sa position d'équilibre à une position hors équilibre déterminée. Une absence subséquente de sollicitation ramène de préférence la partie mobile du transducteur dans sa position d'équilibre. Chaque transducteur peut ainsi présenter un comportement binaire. Le microsystème permet ainsi un actionnement par pas, ou une captation de mouvement, de l'organe externe, y compris lorsque le comportement de chaque transducteur est binaire. Un tel microsystème fonctionne avantageusement avec une électronique simplifiée.

Chaque transducteur peut être sollicité :
- alternativement à l'autre ou à plusieurs autres transducteurs ou
- conjointement à l'un ou à plusieurs autres transducteurs,
notamment de sorte à permettre à la zone libre de la membrane d'atteindre des déformations différentes de celle que permet d'atteindre chaque transducteur isolément.

En alternative ou en complément, la solution proposée permet au microsystème électromécanique de capter :
- un mouvement de l'organe externe vers l'intérieur de la cavité, et/ou
- un mouvement de l'organe externe vers l'extérieur de la cavité.

Ainsi, le microsystème électromécanique tel qu'introduit ci-dessus permet :
- de capter au moins un mouvement de l'organe externe et/ou
- de déplacer l'organe externe selon au moins deux mouvements différents entre eux, au moins par leur amplitude.

Dans le microsystème selon ledit mode optionnel, le troisième transducteur permet :
- soit de déformer davantage la zone libre de la membrane par rapport à ce que permet la sollicitation d'un des deux autres transducteurs,
- soit de réduire la déformation de la zone libre de la membrane par rapport à ce que permet la sollicitation d'un ou des deux autres transducteurs.

Que le troisième transducteur permette d'atteindre une déformation intermédiaire ou accrue par rapport aux déformations que permet d'atteindre la sollicitation d'un ou des deux autres transducteurs, on comprend que, grâce au microsystème selon ledit mode optionnel, au moins trois déformations différentes de la zone libre de la membrane peuvent être atteintes graduellement ou par pas.

Notons en outre que le microsystème selon ledit mode optionnel est ainsi avantageusement moins sensible à un défaut d'un des transducteurs, ceux qui restent fonctionnels continuant à permettre de déplacer l'organe externe vers le haut et/ou vers le bas, ou de capter un mouvement de l'organe externe vers le haut ou vers le bas.

La solution proposée permet en outre au microsystème électromécanique de former un actionneur dit à grand débattement, c'est-à-dire autorisant typiquement le déplacement de l'organe externe sur une longueur de course d'au moins 30 µm, voire de 100 µm (10⁻⁶ mètre). De même, la solution proposée permet au microsystème électromécanique de former un capteur dit à grand débattement, autorisant typiquement à capter un déplacement dont l'amplitude est d'au moins 30 µm, voire de 100 µm (10⁻⁶ mètre).

Le microsystème électromécanique tel qu'introduit ci-dessus est ainsi apte à déplacer pas à pas l'organe externe ou à capter un mouvement de cet organe, et ce en présentant, de façon aisément modulable en fonction des applications visées, une capacité suffisante en termes d'amplitude de déplacement et/ou une capacité suffisante en termes de force déployée et/ou une capacité de captation de mouvement sur une amplitude et/ou avec une précision suffisantes et/ou une capacité suffisante à travailler en fréquence et/ou une taille compatible avec les applications visées, et/ou une consommation en énergie réduite.

Un autre aspect de l'invention concerne un système ou un microsystème opto-électro-mécanique comprenant au moins un microsystème électromécanique tel qu'introduit ci-dessus et au moins un microsystème optique.

Un autre aspect de l'invention concerne un procédé de fabrication d'un microsystème électromécanique tel qu'introduit ci-dessus, comprenant, voire étant limité à, des étapes de dépôt et de gravure ordinaires en microélectronique. Le microsystème électromécanique peut en effet être fabriqué par des moyens ordinaires de la microélectronique, ce qui confère à son fabricant tous les avantages découlant de l'utilisation de ces moyens, dont une grande latitude en termes de dimensionnement, d'énergie d'adhésion entre les différents dépôts, d'épaisseur des différents dépôts, d'étendue de gravure, etc.

Selon un exemple le procédé de fabrication du microsystème électromécanique comprend les étapes suivantes :
- une étape de formation, sur un substrat, d'une portion au moins de chacun desdits au moins deux transducteurs électromécaniques, puis
- une étape de dépôt de la membrane déformable, puis
- une étape de formation d'une cavité ouverte sur la membrane déformable, puis
- une étape de remplissage avec le milieu déformable et de fermeture de la cavité, et
- une étape de gravure du substrat pour former une face avant (FAV) du microsystème électromécanique.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1A est un schéma de principe d'une vue en coupe ou d'une coupe d'un microsystème électromécanique comprenant trois transducteurs électromécaniques selon un premier mode de réalisation de l'invention.
La figure 1B est un schéma de principe d'une vue de haut du microsystème électromécanique selon le premier mode de réalisation de l'invention, un premier des trois transducteurs prenant la forme d'un disque et les deux autres formant chacun un anneau, l'un entourant le premier transducteur et l'autre entourant la zone libre de la membrane.
La figure 1C est un schéma de principe d'une vue en coupe au niveau des transducteurs d'un deuxième mode de réalisation de l'invention.
La figure 1D est un schéma de principe d'une vue en coupe au niveau des transducteurs d'un troisième mode de réalisation de l'invention.
La figure 1E est un schéma de principe d'une vue en coupe au niveau des transducteurs d'un quatrième mode de réalisation de l'invention.
La figure 2 représente schématiquement une vue en coupe ou d'une coupe d'un microsystème électromécanique selon le premier mode de réalisation de l'invention.
La figure 3A représente schématiquement un premier mode de réalisation d'un microsystème opto-électro-mécanique comprenant quatre microsystèmes électromécaniques selon un mode de réalisation de l'invention.
La figure 3B représente schématiquement un deuxième mode de réalisation d'un microsystème opto-électro-mécanique comprenant quatre microsystèmes électromécaniques selon un mode de réalisation de l'invention.
Les figures 4A et 4B représentent chacune schématiquement d'autres modes de réalisation d'un microsystème opto-électro-mécanique comprenant quatre microsystèmes électromécaniques selon un mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs des différentes couches, parois et organes illustrés ne sont pas nécessairement représentatives de la réalité. De même, les dimensions latérales des éléments piézoélectriques, de la zone libre de la membrane et/ou des butées ne sont pas nécessairement représentatives de la réalité, notamment lorsque considérées l'une par rapport à une autre.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

Selon un exemple, deux desdits au moins deux transducteurs électromécaniques s'étendent, sur au moins une des parois de la cavité, à distance de la zone libre de la membrane déformable. Plus particulièrement, ils ne s'étendent pas autour de la zone libre.

Selon l'exemple particulier précédent, le premier transducteur électromécanique a la forme d'un disque de rayon R1 et le deuxième transducteur électromécanique a la forme d'un anneau s'étendant dans une zone d'étendue radiale R2 autour du disque formé par le premier transducteur électromécanique. De préférence, la somme du rayon R1 du disque formé par le premier transducteur électromécanique et de l'étendue radiale R2 de l'anneau formé par le deuxième transducteur électromécanique est inférieure à 900 µm, de préférence inférieure à 600 µm, de préférence inférieure à 300 µm.

En complément ou en alternative à l'exemple précédent, l'étendue radiale R2 de l'anneau formé par le deuxième transducteur électromécanique est environ deux fois plus petite que le rayon R1 du disque formé par le premier transducteur électromécanique.

Selon l'exemple précédent, avec le microsystème comprenant un troisième transducteur électromécanique, et avec les premier deuxième transducteurs électromécaniques s'inscrivant étroitement dans une zone circulaire de rayon déterminé appelé « rayon total » et noté Rₜₒₜ, ladite zone circulaire étant composée de deux parties, une première partie prenant la forme d'un disque centré sur ladite zone circulaire et une seconde partie prenant la forme d'un anneau s'étendant autour de la première partie, ledit au moins un premier transducteur électromécanique s'inscrit plus particulièrement dans la première partie de la zone circulaire et ledit au moins un deuxième transducteur électromécanique s'inscrit plus particulièrement dans la seconde partie de la zone circulaire. La première partie de la zone circulaire présente un rayon R_{2/3} sensiblement égale aux deux tiers du rayon total et la seconde partie de la zone circulaire présente une étendue E_{1/3} sensiblement égale au tiers du rayon total. L'on s'assure ainsi que, lorsque les premier et deuxième transducteurs électromécaniques comprennent un élément piézoélectrique à base de PZT, les premiers et deuxièmes transducteurs électromécaniques aient des mouvements antagonistes entre eux.

En complément ou en alternative à l'exemple précédent, le deuxième transducteur électromécanique peut être configuré de sorte qu'un mouvement de sa partie mobile de sa position d'équilibre à sa position hors équilibre induise un accroissement de la pression externe agissant sur le milieu déformable et la membrane déformable peut être configurée de sorte qu'un accroissement de la pression externe agissant sur le milieu déformable induise une déformation de la zone libre de la membrane déformable tendant à l'éloigner de la cavité (plus précisément à l'éloigner d'une paroi fixe de la cavité telle que la paroi opposée à la paroi formée en partie par la membrane). Le microsystème électromécanique peut ainsi être configuré de sorte à induire un déplacement de l'organe externe dans un premier sens, correspondant à un éloignement de l'organe externe par rapport à la cavité.

En complément à la caractéristique précédente, le premier transducteur électromécanique peut être configuré de sorte qu'un mouvement de sa partie mobile de sa position d'équilibre à sa position hors équilibre induise une déformation de la zone libre de la membrane déformable tendant à la rapprocher de la cavité (plus précisément à la rapprocher d'une paroi fixe de la cavité telle que la paroi opposée à la paroi formée en partie par la membrane). Le microsystème électromécanique peut ainsi être configuré en outre de sorte à induire un déplacement de l'organe externe dans un deuxième sens, ce deuxième sens tendant à rapprocher l'organe externe de la cavité (plus précisément à le rapprocher d'une paroi fixe de la cavité telle que la paroi opposée à la paroi formée en partie par la membrane).

Selon un exemple du mode de réalisation optionnel, le troisième transducteur électromécanique s'étend sur au moins une des parois de la cavité et sur une zone annulaire autour de la zone libre de la membrane déformable. La zone annulaire sur laquelle s'étend le troisième transducteur électromécanique peut définir l'étendue de la zone libre de la membrane déformable. Le troisième transducteur électromécanique peut alors être distant des premier et deuxième transducteurs électromécaniques et/ou ne pas être agencé autour des premier et deuxième transducteurs électromécaniques.

Selon un autre exemple du mode de réalisation optionnel, le microsystème comprend, en alternative ou en complément au troisième transducteur électromécanique selon l'exemple précédent, au moins un autre transducteur électromécanique ayant la forme d'un anneau et s'étendant autour du premier transducteur électromécanique ayant une forme de disque ou autour du deuxième transducteur électromécanique ayant une forme d'anneau. La partie mobile dudit au moins un autre transducteur électromécanique, lorsque ce dernier comprend un élément piézoélectrique à base de PZT, se déforme sous sollicitation, dans des sens opposés entre eux, selon qu'il s'inscrit :
- dans une première partie d'une zone circulaire dans laquelle s'inscrivent étroitement les premier et deuxième transducteurs électromécaniques et ledit au moins un autre transducteur électromécanique, cette première partie présentant un rayon R2/3 sensiblement égale aux deux tiers du rayon de ladite zone circulaire, ou
- dans une seconde partie de la zone circulaire, cette seconde partie présentant une étendue E1/3 sensiblement égale au tiers du rayon de la zone circulaire.

Selon un autre exemple du mode de réalisation optionnel, le microsystème comprend, en alternative ou en complément au troisième transducteur électromécanique et/ou audit au moins un autre transducteur électromécanique, au moins deux autres transducteurs électromécaniques s'étendant, sur au moins une des parois de la cavité, à distance de la zone libre de la membrane déformable et des premiers et deuxième transducteurs électromécaniques et n'étant agencé ni autour de la zone libre de la membrane déformable, ni autour des premier et deuxième transducteurs électromécaniques, un premier desdits au moins deux autres transducteurs électromécaniques ayant la forme d'un disque et un deuxième desdits au moins deux autres transducteurs électromécaniques ayant la forme d'un anneau s'étendant autour du disque formé par le premier desdits au moins deux autres transducteurs électromécaniques. Lesdits au moins deux autres transducteurs électromécaniques peuvent alors présenter les mêmes caractéristiques que les premier et deuxième transducteurs électromécaniques tels qu'introduits ci-dessus.

Selon un exemple, la membrane déformable présente plusieurs zones libres, présentant le cas échéant des formes et/ou des dimensions différentes entre elles.

Lorsque la zone libre est configurée pour coopérer avec au moins un organe externe de sorte que sa déformation induise, ou soit induite par, un mouvement de l'organe externe, la zone libre de la membrane déformable est configurée pour coopérer avec l'organe externe via un pion fixé sur ladite zone libre, de préférence au contact de ladite zone libre et plus précisément au contact d'une face externe de la zone libre.

Selon l'exemple précédent, le pion peut être fixé au centre de chaque zone libre de la membrane déformable. De la sorte, l'on s'assure que le mouvement de chaque pion est un mouvement de translation perpendiculaire au plan dans lequel s'inscrit la paroi de la cavité qui est en partie formée par la membrane déformable, lorsque la membrane n'est pas déformée.

Plusieurs pions peuvent être prévus.

Chaque pion peut être configuré pour coopérer avec l'organe externe par l'intermédiaire d'un guide solidaire de l'organe externe, de sorte à permettre un positionnement automatique de l'organe externe sur le pion.

Chaque pion peut être configuré pour pouvoir être solidarisé avec l'organe externe par collage ou magnétisme, l'énergie d'adhérence du pion sur la zone libre de la membrane déformable étant de préférence supérieure à celle du pion sur l'organe externe. Une solidarisation, éventuellement amovible, de chaque pion et de l'organe externe est ainsi prévue qui est largement modulable en termes de force de retenue.

Selon un exemple, chaque zone libre est libre de se déformer, de préférence de façon élastique, en fonction dudit changement de pression externe.

Le microsystème électromécanique tel qu'introduit ci-dessus est de préférence exempt d'élément optique, telle qu'une lentille, notamment à focale variable.

Au moins une partie de chaque transducteur électromécanique forme une partie de la paroi de la cavité qui est en partie formée par la membrane déformable. Le microsystème électromécanique selon cette caractéristique présente une structure non-traversante, laissant libre les autres parois de la cavité de sorte à pouvoir y réaliser d'autres fonctions ou de sorte à leur permettre de rester inertes, pour une capacité d'intégration accrue notamment dans un microsystème opto-électro-mécanique.

Chaque transducteur électromécanique peut s'étendre, directement ou indirectement, sur la membrane déformable.

Selon un exemple, la partie mobile d'au moins l'un, voire de chacun, desdits au moins deux transducteurs électromécaniques est solidaire d'une zone de la membrane déformable sur laquelle elle s'étend, de sorte qu'un mouvement de ladite partie mobile induise un mouvement correspondant de ladite zone de la membrane déformable.

La membrane déformable est de préférence configurée de sorte que sa zone libre soit capable de se déformer avec une amplitude d'au moins 50 µm, voire d'au moins 100 µm, voire d'au moins 1000 µm, selon une direction perpendiculaire au plan dans lequel elle s'étend principalement lorsqu'elle est au repos. Sans se déchirer et/ou sans usure significative, le microsystème électromécanique offre ainsi la capacité à satisfaire de nombreuses et diverses applications nécessitant un grand débattement, ce dernier étant défini le cas échéant par domaine technique concerné.

La partie mobile d'au moins un, voire de chacun, desdits au moins deux transducteurs électromécaniques peut présenter une surface au moins deux fois supérieure à une surface de ladite zone libre de la membrane déformable. De préférence, la surface des parties mobiles des transducteurs est au moins 5 fois, voire 10 fois, voire 20 fois supérieure à la surface de la zone libre de la membrane déformable, voire à la surface des zones libres de la membrane déformable.

Le microsystème électromécanique peut comprendre en outre au moins une butée latérale configurée pour guider le mouvement d'un organe externe, lorsque la zone libre est configurée pour coopérer avec ledit organe externe de sorte que sa déformation induise, ou soit induite par, un mouvement de l'organe externe.

Ladite au moins une butée latérale peut être supportée par la paroi de la cavité qui est en partie formée par la membrane déformable. Selon un exemple optionnel, ladite butée latérale s'étend à l'opposé de la cavité.

Il est ainsi possible de :
- limiter, de manière contrôlée, fiable et reproductible, l'inclinaison de l'organe externe lors du mouvement de la partie mobile d'un des transducteurs électromécaniques, et/ou
- permettre un auto-positionnement de l'organe externe relativement à la zone libre de la membrane déformable, et/ou
- protéger la membrane déformable, et plus particulièrement sa zone libre, notamment d'un éventuel arrachement, lors d'un report ou d'un collage de l'organe externe.

Selon un exemple, lorsque la zone libre est configurée pour coopérer avec un organe externe de sorte que sa déformation induise, ou soit induite par, un mouvement de l'organe externe et que la zone libre de la membrane déformable est configurée pour coopérer avec l'organe externe via un pion fixé sur ladite zone libre :
le pion peut s'étendre depuis la zone libre de la membrane déformable au-delà de ladite au moins une butée latérale ou
le pion peut s'étendre depuis la zone libre de la membrane déformable en-deçà de ladite au moins une butée latérale.

Le microsystème électromécanique selon l'une ou l'autre de ces deux dernières alternatives offre une capacité d'adaptation satisfaisante à une large variété d'organes externes et d'applications.

Le microsystème électromécanique peut comprendre en outre au moins une butée dite basse supportée par la paroi de la cavité opposée à la zone libre de la membrane déformable, ladite au moins une butée basse s'étendant dans la cavité vers la zone libre. Elle présente une forme et des dimensions configurées pour limiter la déformation de la zone libre de la membrane déformable de sorte à protéger la membrane déformable, et plus particulièrement sa zone libre, notamment d'un éventuel arrachement, en particulier lors d'un report ou d'un collage de l'organe externe. Par ailleurs, ladite au moins une butée basse peut être conformée pour limiter la surface de contact entre la membrane et la paroi de la cavité opposée à la zone libre de la membrane déformable. Cela permet d'éviter que la membrane n'adhère à cette paroi.

Au moins un, de préférence chacun, desdits au moins deux transducteurs électromécaniques peut être un transducteur piézoélectrique, de préférence comprenant un matériau piézoélectrique à base de PZT.

Dans le cas où chaque transducteur électromécanique est un transducteur piézoélectrique comprenant un matériau piézoélectrique à base de PZT et que le microsystème comprend uniquement deux transducteurs électromécaniques s'inscrivant étroitement dans une même zone circulaire de rayon déterminé appelé « rayon total » et noté Rₜₒₜ, ladite zone circulaire étant composée de deux parties, une première partie prenant la forme d'un disque centré sur ladite zone circulaire et une seconde partie prenant la forme d'un anneau s'étendant autour de la première partie, le premier transducteur électromécanique ne s'inscrit de préférence pas entièrement dans la première partie de la zone circulaire, mais en dépasse, ou le deuxième transducteur électromécanique ne s'inscrit de préférence pas entièrement dans la seconde partie de la zone circulaire, mais en dépasse en s'étendant sur la première partie.

Au moins un, de préférence chacun, des transducteurs électromécaniques peut être un transducteur à fonctionnement statique. En alternative ou en complément, au moins un, de préférence chacun, des transducteurs électromécaniques peut être un transducteur à fonctionnement vibratoire à au moins une fréquence de résonance, ladite au moins une fréquence résonance étant de préférence inférieure à 100 kHz, et encore plus préférentiellement inférieure à 1 kHz.

Le milieu déformable contenu hermétiquement dans la cavité peut comprendre au moins un fluide, de préférence liquide. Le fluide présente de préférence une viscosité de l'ordre de 100 cSt (1cSt = 10⁻⁶ m²/s) à température et pression ambiantes.

Selon un exemple de réalisation non limitatif, le fluide présente une compressibilité comprise entre 10⁻⁹ et 10⁻¹⁰ Pa⁻¹ à 20°C, par exemple de l'ordre de 10⁻¹⁰ Pa⁻¹ à 20°C, sans que ces valeurs soient limitatives.

Le microsystème électromécanique tel qu'introduit ci-dessus peut comprendre en outre une pluralité de membranes déformables et/ou une pluralité de zones libres par membrane déformable.

Ledit au moins un microsystème optique du système opto-électro-mécanique tel qu'introduit ci-dessus peut comprendre au moins un miroir également désigné micro-miroir, de préférence à base de silicium.

Selon un exemple, le système opto-électro-mécanique est configuré de sorte à ce que chaque mouvement de la partie mobile d'au moins un, de préférence de chaque, transducteur électromécanique provoque un déplacement de l'au moins un miroir.

En alternative ou en complément, le système opto-électro-mécanique peut comprendre une pluralité de microsystèmes électromécaniques présentant chacun au moins une zone libre agencée en vis-à-vis d'une partie d'un même microsystème optique, tel qu'un miroir. De préférence, le microsystème électromécanique coopère avec le miroir au niveau d'une zone qui n'est pas au centre du miroir mais par exemple dans un coin du miroir. On obtient ainsi un système ou un microsystème opto-électro-mécanique bénéficiant d'une large capacité d'adaptation de son orientation optique.

On entend, par « microsystème électromécanique », un système comprenant au moins un élément mécanique et au moins un transducteur électromécanique réalisés à l'échelle micrométrique avec des moyens de la microélectronique. L'élément mécanique peut être mis en mouvement (actionné) grâce à une force générée par le transducteur électromécanique. Ce dernier peut être alimenté par des tensions électriques produites avec des circuits électroniques avoisinants. En alternative ou en complément, le transducteur électromécanique peut capter un mouvement de l'élément mécanique ; le microsystème électromécanique joue alors le rôle de capteur.

Un « microsystème » est un système dont les dimensions externes sont inférieures à 1 centimètre (10⁻² mètres) et de préférence à 1 millimètre (10⁻³ mètres).

Le plus souvent, un transducteur électromécanique joue un rôle d'interface entre les domaines mécanique et électrique. Toutefois, on entend ici, par « transducteur électromécanique », aussi bien un transducteur piézoélectrique qu'un transducteur thermique, ce dernier jouant un rôle d'interface entre les domaines mécanique et thermique. Un transducteur électromécanique peut comprendre une partie mobile entre une position d'équilibre, hors sollicitation, et une position hors équilibre, sous sollicitation. Lorsque le transducteur est piézoélectrique, la sollicitation est de nature électrique. Lorsque le transducteur est thermique, la sollicitation est de nature thermique.

Lorsqu'il est fait mention du centre de la cavité, ce centre est défini géométriquement en considérant comme le centre d'une cavité présentant une zone libre non déformée de la membrane déformable.

On entend par « inférieur » et « supérieur », « inférieur ou égal » et supérieur ou égal », respectivement. L'égalité est exclue par l'usage des termes « strictement inférieur » et « strictement supérieur ».

On entend par un paramètre « sensiblement égal/supérieur/inférieur à » une valeur donnée que ce paramètre est égal/supérieur/inférieur à la valeur donnée, à plus ou moins 20%, voire 10%, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

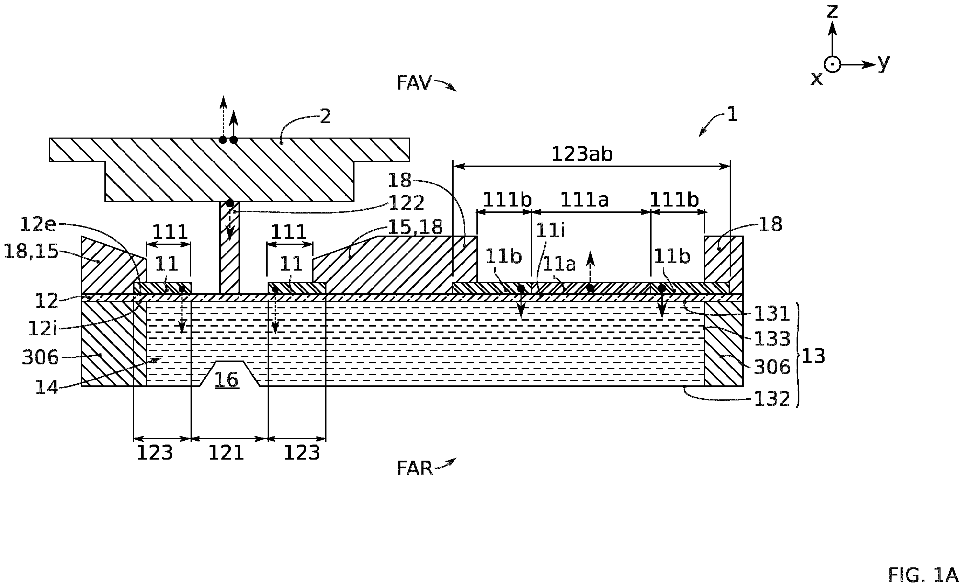

La figure 1A est un schéma de principe d'une vue en coupe ou d'une coupe d'un microsystème électromécanique 1 selon le premier mode de réalisation de l'invention. Sur la figure 1A, sont illustrés trois transducteurs électromécaniques 11, 11a et 11b, une membrane déformable 12 et une cavité 13 configurée pour contenir hermétiquement un milieu déformable 14.

Ce schéma de principe peut aussi bien représenter une structure sans symétrie de rotation ou de révolution autour d'un axe perpendiculaire et centré par rapport à la surface de la membrane déformable telle qu'illustrée, qu'une structure s'étendant, par exemple de façon sensiblement invariante, perpendiculairement à la vue en coupe illustrée et symétrique pour une première partie par rapport à un plan perpendiculaire et centré par rapport à la zone référencée 121 et pour une deuxième partie par rapport à un plan perpendiculaire et centré par rapport à la zone référencée 111a.

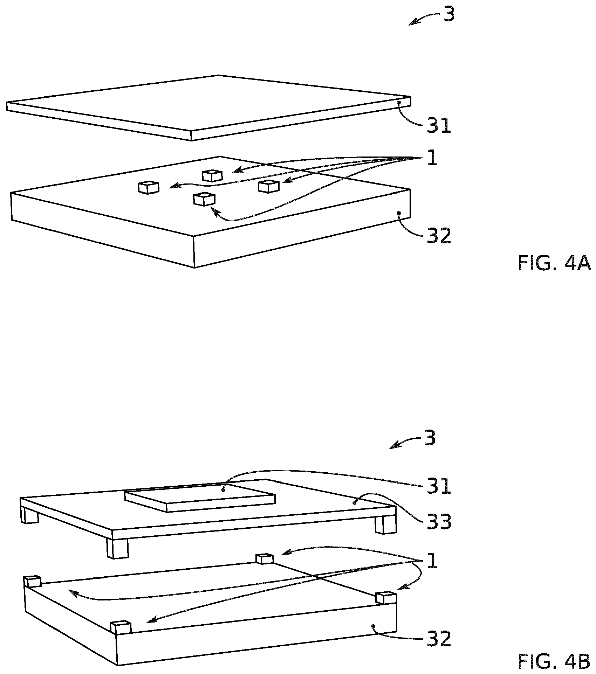

Avant de décrire plus avant les différents modes de réalisation de l'invention illustrés sur les figures annexées, notons en outre que chacune de ces illustrations représente schématiquement un mode de réalisation du microsystème électromécanique selon l'invention qui présente une structure non traversante. Plus particulièrement, les transducteurs électromécaniques 11, 11a 11b, 11c et 11d et la membrane déformable 12 se situent en face avant FAV du microsystème électromécanique 1. Ce type de structure est particulièrement avantageux dans la mesure où la face arrière FAR du microsystème électromécanique 1 peut participer uniquement de façon passive, et en particulier sans se déformer, à la fonction d'actionneur et/ou de capteur du microsystème électromécanique 1. Plus particulièrement, la face arrière FAR d'un microsystème 1 à structure non traversante selon l'invention peut notamment constituer une face par laquelle le microsystème électromécanique 1 peut être aisément monté sur un support (référencé 32 sur les figures 4A et 4B) et/ou peut constituer une face par laquelle le microsystème peut aisément être davantage fonctionnalisé.

Toutefois, l'invention n'est pas limitée aux microsystèmes électromécaniques à structure non traversante. Dans son acceptation la plus large, l'invention concerne également des microsystèmes 1 dits à structure traversante dans lesquels au moins un des transducteurs 11, 11a, 11b, 11c et 11d et la membrane déformable 12 sont agencés sur des parois distinctes entre elles de la cavité 13, que ces parois soient adjacentes ou opposées entre elles.

En référence à la figure 1A, chaque transducteur électromécanique 11, 11a, 11b comprend au moins une partie mobile 111, 111a, 111b. Cette dernière est configurée pour se mouvoir ou être mue entre au moins deux positions. Une première de ces positions est une position d'équilibre atteinte et conservée lorsque le transducteur 11, 11a, 11b n'est pas sollicité, que ce soit par exemple par une tension électrique ou par une force le contraignant hors de sa position d'équilibre. Une deuxième position de la partie mobile 111, 111a, 111b du transducteur 11, 11a, 11b est atteinte lorsque le transducteur est sollicité, que ce soit par exemple par une tension électrique ou par une force le contraignant hors de sa position d'équilibre. Chaque transducteur électromécanique 11, 11a, 11b peut être maintenu dans l'une ou l'autre des première et deuxième positions décrites ci-dessus, et présenter ainsi un comportement binaire, ou être en outre maintenu dans n'importe quelle position intermédiaire entre sa position d'équilibre et sa position de plus grande déformation, ou de plus grande déflexion, par rapport à l'équilibre. Comme cela apparaît clairement à la lecture de la description ci-dessous de l'invention, il est particulièrement avantageux que chaque transducteur électromécanique 11, 11a, 11b ait un comportement binaire. En effet, cela simplifie significativement l'électronique permettant notamment de solliciter aisément chaque transducteur indépendamment ou conjointement à au moins un autre transducteur.

Dans l'exemple illustré, lorsqu'un transducteur électromécanique 11, 11a, 11b n'est pas sollicité, sa partie mobile 111, 111a, 111b s'étend principalement dans un plan parallèle au plan xy du repère orthogonal xyz illustré en figure 1A.

Au moins un, de préférence chaque, transducteur électromécanique 11, 11a, 11b est de préférence un transducteur piézoélectrique. De façon connue, un tel transducteur convertit une énergie électrique d'alimentation en un mouvement de sa partie mobile 111, 111a, 111b de sa position d'équilibre à une position hors équilibre et/ou convertit un mouvement de sa partie mobile 111, 111a, 111b, de sa position d'équilibre à une position hors équilibre, en un signal électrique. Il ressort donc de cet exemple, mais cela reste potentiellement vrai pour chacun des autres modes de réalisation envisagés du microsystème électromécanique 1 selon l'invention, que ce dernier peut fonctionner comme actionneur et/ou comme capteur. En tant qu'actionneur, il peut permettre de déplacer un organe externe 2 vers le haut et/ou vers le bas, comme illustré sur la figure 1A. En tant que capteur, il peut permettre de capter un déplacement, en particulier un déplacement vertical, de l'organe externe 2, comme également illustré sur la figure 1A. De sorte que le signal généré puisse être fonction du déplacement de l'organe externe 2, et en particulier de son amplitude de déplacement, il est préférable que la surface de la zone libre 121 soit supérieure à la surface des parties mobiles 111, 111a, 111b des transducteurs électromécaniques 11, 11a, 11b qui est en contact avec la membrane déformable 12. Ci-dessous, pour des raisons de simplicité, nous décrivons essentiellement le microsystème électromécanique 1 comme un actionneur, sans toutefois exclure sa capacité à assurer, en alternative ou en complément, une fonction de capteur.

Au moins un, voire chaque, transducteur électromécanique 11, 11a, 11b est encore plus préférentiellement un transducteur piézoélectrique comprenant un matériau piézoélectrique à base de PZT (Titano-Zirconate de Plomb). Dans ce cas, la partie mobile 111, 111a, 111b du transducteur 11, 11a, 11b est capable sous sollicitation de se mouvoir avec un déplacement plus significatif (du fait du coefficient piézoélectrique d31) qu'avec bon nombre d'autres matériaux piézoélectriques. Toutefois, le PZT étant un matériau ferroélectrique, de tels transducteurs piézoélectriques fonctionnent chacun préférentiellement dans un seul sens d'actionnement (mouvement dans un unique sens de leur partie mobile 111, 111a, 111b) quelle que soit la polarité de son alimentation électrique, alors qu'un transducteur piézoélectrique à base d'un matériau non-ferroélectrique peut préférentiellement fonctionner dans les deux sens (mouvement dans deux sens opposés de leur partie mobile 111, 111a, 111b). En alternative ou en complément, au moins l'un, voire chaque, transducteur électromécanique 11, 11a, 11b peut être un transducteur piézoélectrique (non ferroélectrique) à base d'un matériau propre à permettre à sa partie mobile 111, 111a, 111b de se mouvoir dans des sens opposés relativement à sa position d'équilibre en fonction de la polarité de son alimentation électrique. Un tel matériau est par exemple un matériau à base de nitrure d'aluminium (AIN).

En alternative ou en complément, au moins un, voire chaque, transducteur électromécanique 11, 11a, 11b peut être ou comprendre un transducteur thermique.

La membrane déformable 12 peut être à base d'un polymère, et est de préférence à base de PDMS (pour polydiméthylsiloxane). Les propriétés de la membrane déformable 12 en particulier son épaisseur, sa surface et sa forme peuvent être configurées pour conférer à la membrane déformable 12, et plus particulièrement à une zone 121 de cette membrane qui est libre de se déformer, une capacité d'étirement escomptée, notamment en fonction de l'application visée.

La cavité 13 telle qu'illustrée notamment sur la figure 1A présente plus particulièrement des parois 131, 132, 133 contenant hermétiquement le milieu déformable 14. Dans les exemples illustrés, la paroi 132 de la cavité 13 constitue la face arrière FAR du microsystème électromécanique 1. La paroi 131 opposée à la paroi 132 est formée au moins en partie par au moins une partie de la membrane déformable 12. Ainsi, la paroi 131 est déformable. La paroi 131 est désignée par la suite première paroi. Elle se situe au niveau de la face avant FAV du microsystème électromécanique 1. Au moins une paroi 133 latérale joint entre elles les parois 131 et 132. Cette paroi 133 latérale peut comprendre ou être constituée d'au moins un espaceur 306 tel qu'illustré sur la figure 1A et dont le rôle est détaillé plus bas. On notera que l'herméticité de la cavité 13 nécessite que la membrane déformable 12 soit elle-même imperméable, ou rendue imperméable, notamment au niveau de sa zone libre 121.

On notera également que, pour assurer plus aisément l'herméticité de la cavité 13 :
- la première paroi 131 de la cavité est de préférence entièrement formée ou recouverte par au moins la membrane déformable 12 et/ou
- chaque transducteur électromécanique 11, 11a, 11b s'étend de toute son étendue sur la membrane déformable 12, en étant au contact, direct ou indirect, de celle-ci.

De préférence, les parois 132, 133 restent fixes lorsque la membrane se déforme.

Le milieu déformable 14 est quant à lui propre à conserver un volume sensiblement constant sous l'action d'un changement de pression externe. Autrement dit, il peut s'agir d'un milieu incompressible ou faiblement compressible dont la déformation nécessite de préférence peu d'énergie. Il s'agit par exemple d'un liquide.

Du fait qu'une partie au moins de la paroi 131 de la cavité 13 est formée par une partie au moins de la membrane déformable 12, l'on comprend que tout changement de pression externe exercée sur le milieu déformable 14 peut être compensé par une déformation, sensiblement proportionnelle, de la membrane déformable 12, et plus particulièrement de sa zone libre 121, et/ou par un déplacement de la partie mobile 111, 111a, 111b d'un des transducteurs électromécaniques 11, 11a, 11b. Lorsque l'un des transducteurs 11, 11a, 11b est sollicité, cette compensation est plus particulièrement liée à une conversion du changement de pression externe exercée sur le milieu déformable 14 en un étirement de la membrane déformable 12. L'on comprend que, dans un souci de reproductibilité de l'actionnement ou de la captation de mouvement qu'offre le microsystème électromécanique 1 selon l'invention, il est préférable que toute déformation de la membrane déformable 12 soit élastique, et non plastique, pour garantir le retour dans un même état de moindre étirement, ou de relaxation maximale, de la membrane déformable 12 chaque fois qu'elle n'est plus contrainte.

Le milieu déformable 14 peut plus particulièrement comprendre au moins un fluide, de préférence liquide. Les paramètres du liquide seront adaptés en fonction des applications visés. L'on s'assure ainsi que tout changement de pression externe exercée sur le milieu déformable 14 induise une déformation sensiblement proportionnelle de la zone libre 121 de la membrane déformable 12. Le fluide peut être constitué ou à base d'un liquide, tel que de l'huile ou peut être constitué ou à base d'un polymère. Selon un exemple, le fluide est à base ou est constituée de glycérine. L'on s'assure ainsi, en plus d'une déformation sensiblement proportionnelle de la membrane 12, de la capacité du milieu déformable 14 à occuper notamment le volume créé par étirement de la zone libre 121 de la membrane déformable 12 à l'opposé du centre de la cavité 13.

L'on comprend de ce qui précède que le microsystème électromécanique 1 est configuré de sorte que chaque mouvement d'un transducteur électromécanique 11, 11a, 11b soit fonction d'un changement de pression externe exercée sur le milieu déformable 14, pour réaliser la fonction d'actionneur du microsystème électromécanique 1, et inversement, pour réaliser la fonction de capteur du microsystème électromécanique 1. Plus particulièrement, lorsque le microsystème électromécanique 1 joue le rôle d'actionneur, au moins un transducteur électromécanique 11, 11a, 11b est sollicité de sorte à exercer un changement de pression externe sur le milieu déformable 14 et induire par-là la déformation de la membrane déformable 12. Inversement, lorsque le microsystème électromécanique 1 joue le rôle de capteur, la déformation de la membrane 12 exerce un changement de pression externe sur le milieu déformable 14 qui induit un déplacement de la partie mobile 111, 111a, 111b d'un des transducteurs électromécaniques 11, 11a, 11b.

Selon l'exemple illustré sur la figure 1A, le microsystème électromécanique 1 est tel que la zone libre 121 de la membrane déformable 12 est configurée pour coopérer avec un organe externe 2. De la sorte, la déformation de la zone libre 121 induit, ou est induite par, un mouvement de l'organe externe 2. C'est donc par l'intermédiaire de la zone libre 121 de la membrane déformable 12 que le microsystème déplace l'organe externe 2 ou capte un mouvement de l'organe externe 2. Ainsi, lorsque le microsystème joue le rôle d'actionneur, l'activation d'un des transducteurs électromécaniques 11, 11a, 11b déforme la membrane 12 ce qui déplace l'organe 2. Inversement, lorsque le microsystème joue le rôle de capteur, un appui d'un organe externe 2 sur la membrane 12 ou une traction de la membrane 12 par un organe externe 2 déforme la membrane 12, ce qui déplace la partie mobile de chacun des transducteurs électromécaniques 11, 11a, 11b puis génère in fine un signal qui peut être fonction de ce déplacement.

Plus particulièrement, la coopération entre la zone libre 121 de la membrane déformable 12 et l'organe externe 2 peut être réalisée via un doigt, également désigné pion 122, qui est fixé sur la zone libre 121. Les termes « doigt » et « pion » peuvent être intervertis. Le terme « pion » ne se limite pas aux pièces de section constante et a fortiori aux pièces cylindriques.

Comme illustré sur la figure 1A, le pion 122 peut être plus particulièrement fixé au centre de la zone libre 121 de la membrane déformable 12, ou plus généralement symétriquement par rapport à l'étendue de la zone libre 121 de la membrane déformable 12. De la sorte, le pion 122 est déplacé, par la déformation élastique de la zone libre 121, dans un sens contrôlé, sensiblement vertical, et n'est pas, ou peu, incliné par rapport à la verticale lors de ses déplacements. Le débattement latéral du pion 122 est ainsi avantageusement limité.

En complément ou en alternative, l'organe externe 2 peut être structuré de sorte à comprendre un guide par lequel l'organe externe 2 est destiné à coopérer avec le pion 122. Ce guide peut lui aussi contribuer à s'opposer à une inclinaison du pion 122 lors de ses déplacements. Nous verrons plus tard que les limitations ainsi atteintes en termes de débattement latéral du pion 122 peuvent encore être renforcées par la présence d'au moins une butée latérale 15 s'étendant depuis une partie de la paroi 131 située hors de la zone libre 121 de la membrane déformable 12.

De façon non limitative, un collage ou une aimantation du pion 122 sur l'organe externe 2 peut permettre de solidariser entre eux le pion 122 et l'organe externe 2. L'énergie d'adhérence du pion 122 sur la zone libre 121 de la membrane déformable 12 est de préférence supérieure à celle du pion 122 sur l'organe externe 2. L'énergie d'adhérence du pion 122 sur la zone libre 121 peut être une résultante d'étapes technologiques ordinaires dans le domaine de la micro-électronique. Cette énergie d'adhérence pouvant ainsi être estimée ou mesurée, il est aisé d'obtenir par collage, par exemple à l'aide d'une résine *ad hoc,* ou par aimantation, par exemple une solidarisation qui soit d'une énergie plus faible que l'énergie avec laquelle le pion 122 est solidarisé avec la membrane déformable 12. On comprend donc que la solidarisation entre le pion 122 et l'organe externe 2 est ainsi largement modulable en termes de force de retenue. Cette modularité peut permettre notamment de rendre amovible la solidarisation entre le pion 122 et l'organe externe 2, par exemple pour permettre à un même microsystème électromécanique 1 selon l'invention d'être agencé successivement avec plusieurs organes externes 2 avec chacun desquels il serait solidarisé, puis désolidarisé.

Comme illustré sur la figure 1A, chaque transducteur électromécanique 11, 11a, 11b peut former une partie de la première paroi 131 de la cavité 13. Les transducteurs électromécaniques 11, 11a et 11b et la membrane déformable 12 sont ainsi placés d'un même côté de la cavité 13. Les structures présentant cette caractéristique sont avantageusement non traversantes, comme évoqué plus haut.

Sur cet exemple non limitatif, la membrane 12 présente une face interne 12i configurée pour être au contact du milieu déformable 14 et une face externe 12e. La face interne 12i forme une partie de la première paroi 131 de la cavité 13. De préférence, pour assurer aisément l'herméticité de la cavité 13, la face interne 12i de la membrane déformable 12 forme toute la première paroi 131 de la cavité 13. Chaque transducteur électromécanique 11, 11a, 11b, plus précisément la partie mobile 111, 111a, 111b de celui-ci, présente une face interne 11i tournée au regard, et de préférence au contact de la face externe 12e de la membrane 12. Chaque transducteur électromécanique 11a, 11b présente également une face externe 11e, opposée à la face interne 11i, et tournée vers l'extérieur du microsystème électromécanique 1. De préférence, pour assurer aisément l'herméticité de la cavité 13, la face interne 11i de chaque transducteur électromécanique 11, 11a, 11b est de préférence entièrement au contact de la face externe 12e de la membrane 12. On peut prévoir qu'une ou des couches intermédiaires soient disposées entre la face externe 12e de la membrane 12 et la face interne 11i de chaque transducteur 11, 11a, 11b. Le microsystème électromécanique 1 est configuré de sorte que le mouvement de la partie mobile 111, 111a, 111b de chaque transducteur électromécanique 11, 11a, 11b provoque une déformation de la membrane 12 et donc de la première paroi 131 qui enferme le milieu 14.

On remarquera que, sur la figure 1A :
- chaque transducteur électromécanique 11, 11a, 11b s'étend sur la membrane déformable 12, le transducteur électromécanique 11 définissant la zone libre 121 de la membrane déformable 12, et
- la membrane déformable 12 sépare chaque transducteur électromécanique 11, 11a, 11b, de préférence sur toute leur étendue, du milieu déformable 14.

En outre, chaque transducteur électromécanique 11, 11a et 11b peut avantageusement être solidaire de la membrane déformable 12. Plus particulièrement, les transducteurs électromécaniques 11a et 11b ne définissant pas la zone libre 121 de la membrane déformable 12 peuvent avantageusement être solidaires de la membrane déformable 12 sur une zone 123ab située hors de la zone libre 121, et plus particulièrement sur une zone 123ab distante de la zone libre 121, de sorte que tout mouvement de la partie mobile 111a, 111b de chacun de ces transducteurs 11a et 11b induise, notamment sur cette zone 123ab, un étirement ou une relaxation de la membrane déformable 12. Ainsi, dans l'exemple illustré sur la figure 1A, lorsque le premier transducteur 11a est sollicité de sorte à se déplacer vers le haut (comme illustré par la flèche en tirets s'étendant depuis la partie mobile 111a du transducteur 11a), une diminution de la pression externe exercée sur le milieu déformable 14 est observée, qui induit la déformation de la membrane déformable 12 vers le bas, i.e. vers le centre de la cavité 13.

Toujours dans l'exemple illustré sur la figure 1A, lorsque le deuxième transducteur 11b est sollicité de sorte à se déplacer vers le bas (comme illustré par les flèches en trait plein s'étendant depuis la partie mobile 111b du transducteur électromécanique 11), une augmentation de la pression externe exercée sur le milieu déformable 14 est observée, qui induit l'étirement de la membrane déformable 12 vers le haut, i.e. à l'opposé du centre de la cavité 13. Notons ici que cette solidarisation entre le deuxième transducteur 11b et la membrane déformable 12 n'est que préférentielle pour le microsystème illustré, dans la mesure où la partie mobile 111b du deuxième transducteur 11b est destinée à appuyer sur la membrane déformable 12 lorsque le deuxième transducteur 11b est sollicité et/ou dans la mesure où la membrane déformable 12 a naturellement tendance à rester au contact de la partie mobile 111b du deuxième transducteur 11b lorsque ce dernier n'appuie pas sur la membrane déformable 12.

Selon l'exemple illustré sur la figure 1A, le troisième transducteur 11 est configuré pour se déplacer vers le bas, c'est-à-dire vers le centre de la cavité 13, lorsqu'il est sollicité. Ceci est particulièrement avantageux car il simplifie significativement le procédé de fabrication du microsystème 1, en particulier relativement à un microsystème qui comprendrait un troisième transducteur 11 configuré pour se déplacer vers le haut, c'est-à-dire à l'opposé du centre de la cavité 13. Toutefois, bien que significativement plus complexe, la fabrication d'un tel microsystème 1 est envisageable ; et la portée des revendications ci-dessous n'exclut pas nécessairement un tel microsystème.

A noter que, dans sa position d'équilibre, la partie mobile 111, 111a, 111b de chaque transducteur électromécanique 11, 11a, 11b, et plus généralement un, voire chaque, transducteur, peut ne pas être plat, mais peut au contraire présenter une déflexion, dite déflexion à l'équilibre, qui n'enlève rien, en termes d'amplitude, à la capacité de déplacement ou de déflexion du transducteur 11, 11a, 11b alimenté électriquement.

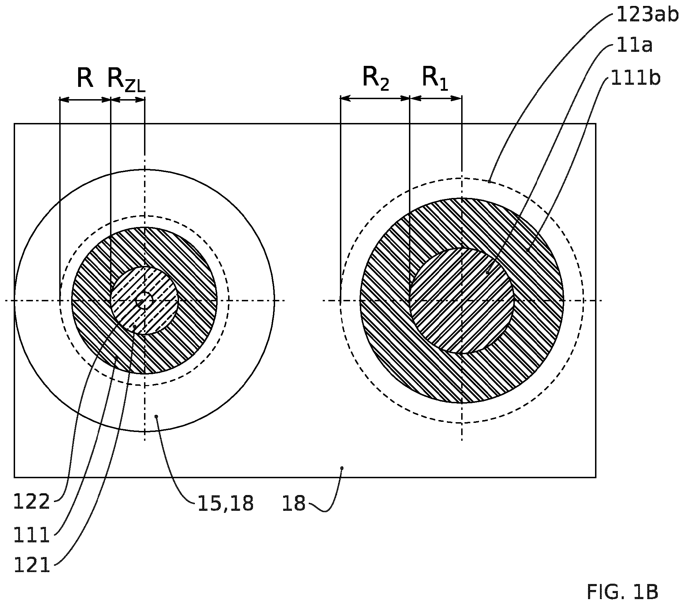

En référence aux figures 1A et 1B, un capot 18 peut être prévu qui est configuré, et qui est plus particulièrement suffisamment rigide, pour maintenir :
- la membrane 12 au moins autour de la zone 123 sur laquelle s'étend le troisième transducteur électromécanique 11 et/ou autour de la zone 123ab sur laquelle s'étendent les premier et deuxième transducteurs 11a et 11b, la membrane 12 est ainsi en partie située entre le capot 18 et le milieu déformable 14, et
- la partie non mobile du troisième transducteur électromécanique 11 et la partie non mobile du deuxième transducteur électromécanique 11b sur lesquelles il s'étend.

Le capot 18 s'étend par exemple dans le plan xy. Il présente au moins une ouverture qui définit la zone dans laquelle s'étend la partie mobile 111 du troisième transducteur électromécanique 11 et au moins une ouverture dans laquelle s'étendent les parties mobiles des premier et deuxième transducteurs électromécaniques 11a et 11b. Dans la zone située autour de la zone libre 121 de la membrane déformable 12, le capot 18 a non seulement le rôle de maintien susmentionné, mais peut également avoir un rôle de butées latérales 15 (Cf. infra).

Comme illustré sur la figure 1A, au moins un espaceur 306 peut être prévu qui a essentiellement pour rôle de contribuer avec le capot 18 au maintien de la partie mobile 111 du troisième transducteur électromécanique 11 et de la partie non mobile du deuxième transducteur 11b. Effectivement, ledit au moins un espaceur 306 illustré sur la figure 1A s'étend au moins au droit d'une partie du capot 18 qui, à gauche de la figure, recouvre la partie non mobile du troisième transducteur électromécanique 11 et qui, à droite de la figure, recouvre la partie non mobile du deuxième transducteur électromécanique 11b, chacune de ces parties non mobiles étant ainsi pincée entre le capot 18 et l'espaceur 306. Ledit au moins un espaceur 306 peut former une partie au moins de la paroi latérale 133 de la cavité 13. Notons qu'il est également possible de prévoir un espaceur au droit d'une partie du capot 18 qui est centrée relativement à l'étendue de la cavité 13 dans le plan (x,y), et en particulier d'une telle partie du capot 18 qui s'étend également sur la partie non mobile du deuxième transducteur 11b.

La figure 1B illustre le recouvrement partiel de la membrane déformable 12 par le troisième transducteur électromécanique 11. Le troisième transducteur électromécanique 11 y prend la forme d'un anneau d'étendue radiale notée R et définit une zone libre 121 circulaire de rayon noté R_{ZL}. Notons que le troisième transducteur électromécanique 11 n'est pas limité à une forme annulaire, mais peut prendre d'autres formes, et notamment une forme oblongue ou ovale, une forme triangulaire, rectangulaire, etc. définissant une pluralité correspondante de formes de la zone libre 121 de la membrane déformable 12. Cette illustration vaut en particulier pour une structure locale à symétrie de rotation ou de révolution.

Notamment lorsque le recouvrement partiel de la membrane déformable 12 par le troisième transducteur électromécanique 11 est tel qu'illustré sur la figure 1B et que le troisième transducteur électromécanique 11 est un transducteur piézoélectrique comprenant un matériau piézoélectrique à base de PZT, il est intéressant que la partie mobile 111 du troisième transducteur 11 présente une surface au moins 2 fois, voire 5 fois, voire 10 fois, voire 20 fois, supérieure à la surface de la zone libre 121 de la membrane déformable 12. La membrane déformable 12 est dès lors configurée de sorte que sa zone libre 121 est capable de se déformer avec une amplitude d'au moins 50 µm, d'environ 100 µm, voire de plusieurs centaines de microns.

De manière générale, la membrane déformable 12 est de préférence configurée de sorte que sa zone libre 121 est capable de se déformer avec une amplitude inférieure à 1mm.

L'amplitude de déformation de la zone libre 121 est mesurée selon une direction perpendiculaire au plan dans lequel s'étend principalement la face externe 12e de la membrane 12 au repos.

Egalement lorsque le recouvrement partiel de la membrane déformable 12 par le transducteur électromécanique 11 est tel qu'illustré sur la figure 1B et que le troisième transducteur électromécanique 11 est un transducteur piézoélectrique comprenant un matériau piézoélectrique à base de PZT, le rayon RZL de la zone libre 121 de la membrane déformable 12 peut être sensiblement égal à 100 µm et l'étendue radiale R du troisième transducteur électromécanique 11 peut être sensiblement égale à 350 µm. Les références R et RZL sont illustrées en figure 1B.

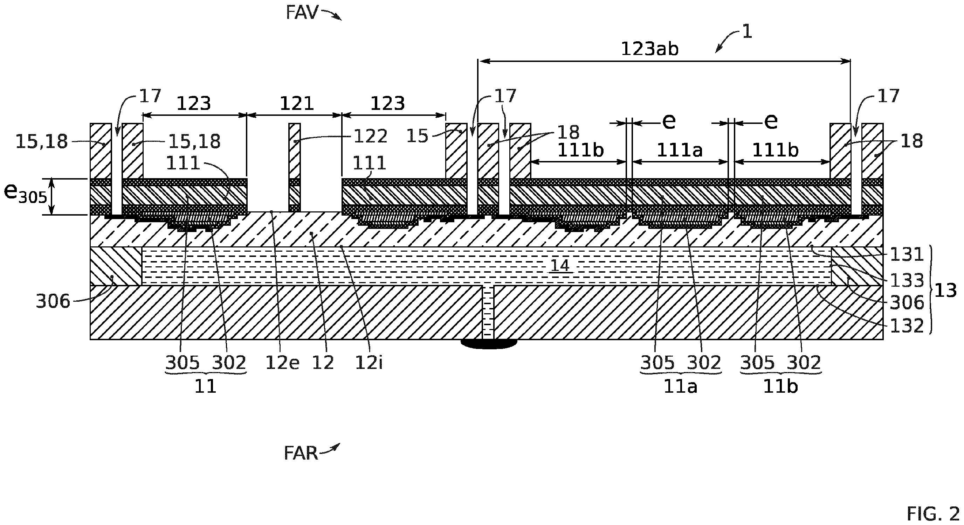

Toujours lorsque le recouvrement partiel de la membrane déformable 12 par le troisième transducteur électromécanique 11 est tel qu'illustré sur la figure 1B et que le troisième transducteur électromécanique 11 est un transducteur piézoélectrique comprenant un matériau piézoélectrique à base de PZT, mais en référence à la figure 2 discutée plus en détails ci-dessous, le troisième transducteur électromécanique 11 comprend plus particulièrement un élément constituant une poutre 305 et un élément piézoélectrique 302 à base de PZT, ce dernier étant configuré pour induire une déflexion de la poutre 305. L'épaisseur de l'élément piézoélectrique 302 peut être sensiblement égale à 0,5 µm et l'épaisseur de la poutre 305 est par exemple comprise entre quelques microns et plusieurs dizaines de microns, par exemple 5 µm. Dans une telle configuration, la partie mobile 111 du troisième transducteur électromécanique 11 peut être déplacée ou défléchie avec une amplitude sensiblement égale à 15 µm en étant parcourue par une tension électrique égale à quelques dizaines de volt.

La figure 1B illustre également le recouvrement partiel de la membrane déformable 12 par les premier et deuxième transducteurs électromécaniques 11a et 11b selon le premier mode de réalisation de l'invention. Le premier transducteur 11a y prend la forme d'un disque de rayon noté R1. Le deuxième transducteur 11b y prend la forme d'un anneau s'étendant autour du disque 11a sur une zone d'étendue radiale R2. Le disque 11a et l'anneau 11b sont de préférence concentriques. Le disque 11a et l'anneau 11b peuvent être, comme représentés, adjacents entre eux, l'anneau 11b présentant alors une étendue radiale égale à R2. En alternative, le disque 11a et l'anneau 11b peuvent être espacés entre eux, l'anneau 11b présentant alors une étendue radiale inférieure à R2.

Le rayon R1 du disque 11a est par exemple compris entre quelques dizaines et quelques centaines de microns, et typiquement égal à 200 microns. L'étendue radiale R2 de la zone s'étendant autour du disque 11a est par exemple comprise entre quelques dizaines et quelques centaines de microns, et typiquement égale à 100 microns. Lorsque les premier et deuxième transducteurs 11a et 11b sont espacés entre eux, l'étendue radiale de cet espacement est par exemple compris entre 1 et 10 microns, et typiquement égale à 5 microns. On comprend ici que chacun des premier et deuxième transducteurs électromécaniques 11a et 11b comprenant une partie mobile 111a, 111b qui lui est propre, la partie mobile d'un des deux transducteurs 11a et 11b peut être sollicitée indépendamment, et notamment alternativement, à la partie mobile de l'autre des deux transducteurs 11a et 11b.

Dans une configuration selon laquelle les premier deuxième transducteurs électromécaniques 11a et 11b s'inscrivent étroitement dans une zone circulaire de rayon déterminé appelé « rayon total » et noté Rₜₒₜ, ladite zone circulaire étant composée de deux parties, une première partie prenant la forme d'un disque centré sur ladite zone circulaire et une seconde partie prenant la forme d'un anneau s'étendant autour de la première partie, ledit au moins un premier transducteur électromécanique 11a peut s'inscrire dans la première partie de la zone circulaire et ledit au moins un deuxième transducteur électromécanique 11b peut s'inscrire dans la seconde partie de la zone circulaire. Alors, si la première partie de la zone circulaire présente un rayon R_{2/3} sensiblement égale aux deux tiers du rayon total et si la seconde partie de la zone circulaire présente une étendue E_{1/3} sensiblement égale au tiers du rayon total, la déformation de la partie mobile 111a du premier transducteur électromécanique 11a est antagoniste, et plus particulièrement dans un sens opposé dans la direction de l'axe z, à la déformation de la partie mobile 111b du deuxième transducteur électromécanique 11b. Il est alors possible, même lorsque chacun des deux transducteurs 11a et 11b comprend un transducteur piézoélectrique à base de PZT, d'induire alternativement, en fonction de celui des deux transducteurs 11a et 11b qui est sollicité, un éloignement et un rapprochement de la zone libre 121 de la membrane 12 relativement à au moins une paroi parmi les parois 132, 133 de la cavité 13. Par exemple, le premier transducteur électromécanique 11a est configuré pour se mouvoir vers le haut, i.e. à l'opposé du centre de la cavité 13, lorsqu'il est sollicité, et le deuxième transducteur électromécanique 11b est configuré pour se mouvoir vers le bas, i.e. vers le centre de la cavité 13, lorsqu'il est sollicité.

En complément, il est avantageux que l'étendue radiale R2 du deuxième transducteur 11b soit environ deux fois plus petite que le rayon R1 du premier transducteur 11a. Dans une telle configuration, la partie mobile 111a du premier transducteur 11a et la partie mobile 111b du deuxième transducteur 11b peuvent être déplacées ou défléchies avec une amplitude sensiblement égale, lorsque les transducteurs sont alternativement et sensiblement pareillement sollicités.

Egalement lorsque le recouvrement partiel de la membrane déformable 12 par les deux transducteurs 11a et 11b est tel qu'illustré sur la figure 1B et que les transducteurs 11a et 11b sont des transducteurs piézoélectriques comprenant chacun un matériau piézoélectrique à base de PZT, le rayon R_{ZL} de la zone libre 121 de la membrane déformable 12 peut être sensiblement égal à 100 µm pour un rayon R1+R2 de 300 µm et/ou le rayon R1 du premier transducteur électromécanique 11a peut être sensiblement égal à 200 µm pour un rayon R1+R2 de 300 µm. Les références R_{ZL}, R, R1 et R2 sont illustrées en figure 1B.

Chacun des premier et deuxième transducteurs électromécaniques 11a et 11b comprend plus particulièrement un élément constituant une poutre 305 et un élément piézoélectrique 302 à base de PZT, ce dernier étant configuré pour induire une déflexion de la poutre 305. L'épaisseur de l'élément piézoélectrique 302 peut être sensiblement égale à 0,5 µm et l'épaisseur de la poutre 305 est par exemple comprise entre quelques microns et plusieurs dizaines de microns, par exemple 5 µm. Dans une telle configuration, lorsque R1 est égal à 200 microns et R2 est égal à 100 microns, l'amplitude de déplacement des parties mobiles 111a, 111b des transducteurs 11a et 11b peut atteindre une valeur égale à quelques dizaines de microns, en particulier lorsque l'un ou l'autre des transducteurs 11a et 11b est parcouru par une tension électrique égale à quelques dizaines de volt.

On observe immédiatement sur la figure 1B que la zone libre 121 de la membrane 12 est à distance, ou est disjointe, de la zone 123ab sur laquelle les premier et deuxième transducteurs 11a et 11b recouvrent la membrane 12. Autrement dit, la zone libre 121 et la zone 123ab ne se recouvrent pas l'une l'autre et ne sont pas non plus adjacentes entre elles. Une distance est donc ménagée entre la zone 121 et la zone 123ab.

On observe encore immédiatement sur la figure 1B que la zone libre 121 de la membrane 12 est décentrée par rapport à la zone 123ab sur laquelle les deux transducteurs 11a et 11b recouvrent la membrane 12. Cette caractéristique est liée au fait que le premier transducteur 11a prend la forme d'un disque, et est donc plein.

Sans se déchirer et/ou sans usure significative, le microsystème électromécanique 1 permet une amplification hydraulique de l'action et offre ainsi la capacité à satisfaire de nombreuses et diverses applications nécessitant un grand débattement. Dans ce contexte, le microsystème électromécanique 1 illustré sur la figure 1A peut être défini comme un actionneur à grand débattement ascendant et/ou descendant.

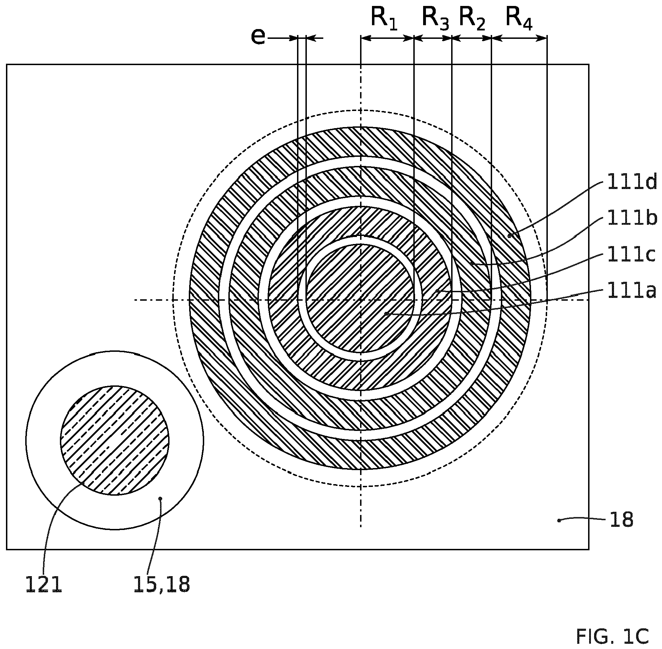

On observe encore, sur la figure 1B, que ladite au moins une butée latérale 15 peut prendre la forme d'un anneau s'étendant depuis la première paroi 131 de la cavité et autour de la zone libre 121 de la membrane 12. De mêmes observations peuvent être faites sur la base de la figure 1C.

La figure 1C illustre, selon un deuxième mode de réalisation de l'invention, le recouvrement partiel de la membrane déformable 12 par quatre transducteurs électromécaniques 11a, 11b, 11c et 11d, représentés chacun par leur parties mobiles 111a, 111b, 111c et 111d. La figure 1C est plus particulièrement une vue de dessus du microsystème électromécanique selon le deuxième mode de réalisation de l'invention. Le premier transducteur électromécanique 11a y prend la forme d'un disque d'étendue radiale R1 ; Le deuxième transducteur électromécanique 11b y prend la forme d'un anneau s'étendant autour du disque 11a sur une zone d'étendue radiale R2 ; Le troisième transducteur électromécanique 11c y prend la forme d'un anneau s'étendant entre le disque 11a et l'anneau 11b sur une zone d'étendue radiale R3 ; Et le quatrième transducteur électromécanique 11d prend la forme d'un anneau s'étendant autour de l'anneau 11b sur une zone d'étendue radiale R4.

Les troisième et quatrième transducteurs 11c et 11d viennent, dans l'exemple illustré sur la figure 1C, en alternative du troisième transducteur 11 tel qu'illustré sur la figure 1B. Selon un mode de réalisation hybride (non représenté) entre les premier et deuxième modes de réalisation du microsystème selon l'invention, les transducteurs 11c et 11d peut venir en complément, plutôt qu'en alternative, au troisième transducteur 11 tel qu'illustré sur la figure 1B.

Les transducteurs 11a, 11b, 11c et 11d selon le deuxième mode de réalisation de l'invention sont de préférence concentriques. Deux transducteurs électromécaniques 11a, 11b, 11c et 11d radialement successifs entre eux sont soit espacés, soit adjacents. Leurs parties mobiles sont par exemple séparées entre elles d'une distance notée e sur la figure 1C. Cette distance peut être rapprochée de celle notée également e sur la figure 2 détaillée ci-dessous. Toutefois, sur cette dernière figure, la distance e vise davantage à illustrer qu'il est nécessaire que les éléments piézoélectriques 302 de transducteurs adjacents entre eux ne doivent pas se toucher pour pouvoir être isolés électriquement entre eux, qu'à illustrer qu'il est possible d'espacer entre eux les transducteurs, y compris lorsque ceux-ci sont agencés de façon concentrique entre eux.

Dans le mode de réalisation illustré sur la figure 1C, R1 est par exemple compris entre 10 et 100 µm microns, R2 entre 10 et 100 µm microns, R3 entre 10 et 100 µm microns, et R4 entre 10 et 100 µm. Typiquement, R1 est égal à 100 microns, R2 est égal à 50 microns, R3 est égal à 50 microns et R4 est égal à 50 microns. Lorsque deux transducteurs électromécaniques radialement successifs entre eux sont espacés l'un de l'autre, l'étendue radiale de cet espacement est par exemple compris entre 1 et 10 microns, et typiquement égale à 10 microns.

La déformation des parties mobiles 111a et 111c des transducteurs 11a et 11c peut avantageusement être antagoniste à la déformation des parties mobiles 111b et 111d des transducteurs 11b et 11d. A cette fin, les transducteurs 11a et 11c peuvent s'inscrire dans un disque de rayon inférieur aux 2/3 de l'étendue radiale totale R1+R3+R2+R4 des transducteurs.

En alternative, le transducteur 11a peut s'inscrire dans une première zone circulaire de rayon inférieur aux deux tiers de l'étendue radiale totale R1+R3+R2+R4 des transducteurs et les trois autres transducteurs 11b, 11c et 11d peuvent s'étendre au-delà de la première zone circulaire sur une zone annulaire d'étendue radiale inférieure aux tiers de l'étendue radiale totale R1+R3+R2+R4 des transducteurs.

Une autre alternative consiste à considérer que les trois transducteurs 11a, 11b et 11c sont situés dans la première zone circulaire de rayon inférieur aux deux tiers de l'étendue radiale totale R1+R3+R2+R4 et que le quatrième transducteur électromécanique 11d est situé dans la zone annulaire d'étendue radiale inférieure au tiers de l'étendue radiale totale R1+R3+R2+R4 des transducteurs.

Comme déjà discuté ci-dessus en référence au mode de réalisation illustré sur la figure 1B, il est possible, même lorsque chacun des transducteurs 11a, 11b, 11c et 11d comprend un transducteur piézoélectrique à base de PZT, d'induire alternativement, en fonction de celui des transducteurs 11a, 11b, 11c et 11d qui est sollicité, un éloignement et un rapprochement de la zone libre 121 de la membrane 12 relativement à au moins une paroi parmi les parois 132 et 133 de la cavité 13. Par exemple, chacun des premier et troisième transducteurs électromécaniques 11a et 11c est configuré pour se mouvoir vers le haut, i.e. à l'opposé du centre de la cavité 13, lorsqu'il est sollicité, et chacun des deuxième et quatrième transducteurs 11b et 11d est configuré pour se mouvoir vers le bas, i.e. vers le centre de la cavité 13, lorsqu'il est sollicité.

On comprend qu'un avantage additionnel, par rapport au premier mode de réalisation illustré schématiquement sur les figures 1A et 1B, est que le mode de réalisation illustré sur le figure 1C peut permettre d'obtenir davantage de niveaux d'éloignement de la zone libre 121 différents entre eux et davantage de niveaux de rapprochement de la zone libre 121 différents entre eux. Le microsystème électromécanique 1 selon le deuxième mode de réalisation de l'invention constitue donc un actionneur pas à pas, propre à déformer la zone libre 121 entre au moins quatre positions d'élévation et/ou de rapprochement, y compris lorsque chacun des transducteurs 11a, 11b, 11c et 11d fonctionne sur un mode binaire. Selon ce mode binaire, la tension d'alimentation de chacun des transducteurs 11a, 11b, 11c et 11d peut alternativement varier entre 0 V et 20 V.

Dans une telle configuration, lorsque les transducteurs 11a et 11c s'inscrivent dans un disque de rayon inférieur aux 2/3 de l'étendue radiale totale R1+R3+R2+R4 des transducteurs :
- la partie mobile 111a du premier transducteur 11a peut être déplacée ou défléchie avec une amplitude comprise entre quelques microns et quelques dizaines de microns en étant parcourue par une tension électrique d'une dizaine de volts ; les parties mobiles 111a et 111c des premier et troisième transducteurs 11a et 11c peuvent être conjointement déplacées ou défléchies avec une amplitude supérieure en étant parcourue tous deux par une même tension d'une dizaine de volts ;
- la partie mobile 111b du deuxième transducteur 11b peut être déplacée ou défléchie avec une amplitude comprise entre quelques microns et quelques dizaines de microns en étant parcourue par une tension électrique d'une dizaine de volts; et les parties mobiles 111b et 111d des deuxième et quatrième transducteurs 11b et 11d peuvent être conjointement déplacées ou défléchies avec une amplitude supérieure en étant parcourue tous deux par une même tension d'une dizaine de volts.

L'on comprend que la configuration illustrée sur la figure 1C permet d'atteindre, en alimentant les transducteurs avec une tension sensiblement égale à une dizaine de volts, des amplitudes de déformation de la zone libre 121 de la membrane 12 sensiblement équivalentes à celles potentiellement atteintes par les seuls premiers et deuxièmes transducteurs 11a et 11b alimentés alternativement avec une tension électrique bien supérieure, et par exemple sensiblement égale à 50 V. Ainsi, une simplification accrue de l'électronique nécessaire à la mise en œuvre du microsystème 1 est obtenue.

Notons ici que le microsystème électromécanique 1 selon le deuxième mode de réalisation n'est pas limité à l'exemple illustré comprenant deux transducteurs 11c et 11d additionnels (présentant chacun une forme annulaire) relativement au premier mode de réalisation. Plus particulièrement, le deuxième mode de réalisation s'étend à un cas comprenant un unique transducteur additionnel (de forme annulaire) et à un cas comprenant plus de deux de transducteurs additionnels (de forme annulaire).

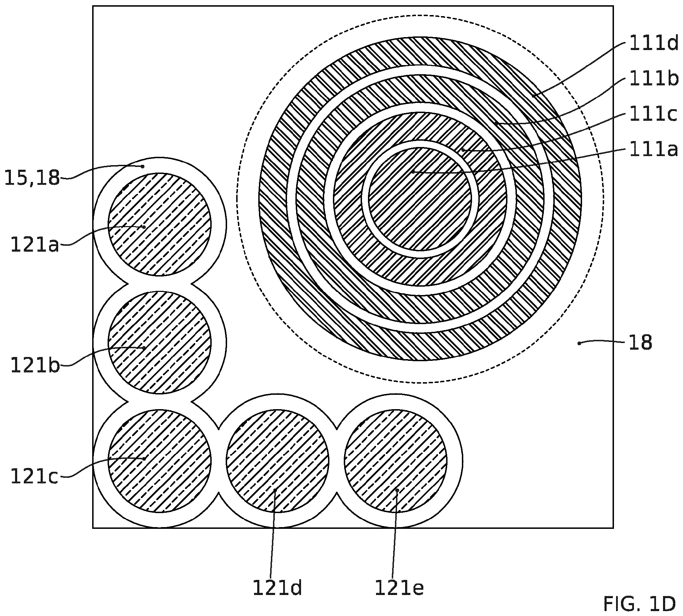

Un troisième mode de réalisation est illustré sur la figure 1D, qui peut être considéré comme en tout point conforme au deuxième mode de réalisation décrit ci-dessus en référence à la figure 1C, à la différence qu'il présente plusieurs zones libres 121a, 121b, 121c, 121d, et 121e. Chacune de ces dernières peut être d'une surface plus limitée, voire jusqu'à cinq fois plus petite, que la surface d'une unique zone libre 121 telle qu'illustrée sur la figure 1C. Par un autre exemple, la surface de chaque partie mobile ou des parties mobiles des transducteurs illustrés sur la figure 1D est au moins 5 fois, voire 10 fois, voire 20 fois supérieure à la surface des zones libres 121a, 121b, 121c, 121d, et 121e de la membrane déformable 12. Elles peuvent en outre avoir des dimensions et/ou des formes différentes entre elles. Une répartition de l'effort de déplacement d'un même organe externe 2 agencé en vis-à-vis d'une telle pluralité de zones libres peut ainsi être avantageusement atteinte. En alternative ou en complément, une plus grande stabilité dans le déplacement de l'organe externe 2 agencé en vis-à-vis d'une telle pluralité de zones libres peut ainsi être avantageusement atteinte, notamment lorsque l'étendue de l'organe externe est significative par rapport à la surface d'une unique zone libre 121 telle qu'illustrée sur la figure 1C. En alternative, un organe externe 2 peut être agencé en vis-à-vis d'une unique zone libre de la pluralité ou de quelques zones libres de la pluralité ; un déplacement conjoint de plusieurs organes externes 2 peut ainsi être obtenu.

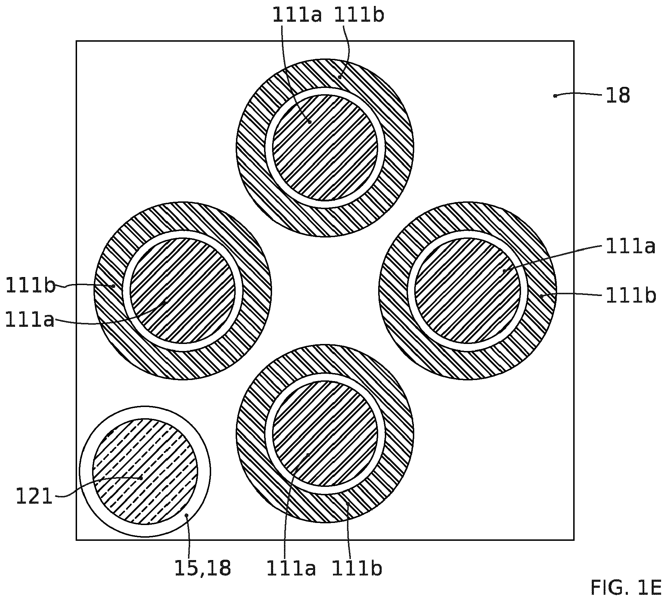

Un quatrième mode de réalisation est illustré sur la figure 1E, qui peut être considéré comme en tout point conforme au premier mode de réalisation décrit ci-dessus en référence aux figures 1A et 1B, à la différence que le quatrième mode de réalisation tel qu'illustré sur la figure 1E ne comprend pas un transducteur 11 définissant la zone libre 121 de la membrane 12, mais comprend, en lieu et place de ce transducteur 11, trois ensembles additionnels de premier et deuxième transducteurs 11a et 11b. Toutefois, le quatrième mode de réalisation n'est pas limité à l'exemple illustré sur la figure 1E; notamment, un ou deux ensembles additionnels ou davantage d'ensembles additionnels que les trois illustrés sont envisagés.

On comprend, de l'exemple illustré sur la figure 1E, que l'amplitude de déformation de la zone libre de la membrane peut être multipliée par quatre relativement à un cas ne comprenant qu'un seul ensemble de premier et deuxième transducteurs 11a et 11b; la zone libre 121 peut dès lors être d'une surface significativement accrue pour une même amplitude de déformation relativement au premier mode. En alternative, on comprend de l'exemple illustré sur la figure 1E, que la tension d'alimentation de chaque transducteur peut être réduite par rapport à une tension d'alimentation nominale, pour obtenir une amplitude de déformation de la zone libre de la membrane comparable à celle potentiellement obtenue en alimentant un unique ensemble de premier et deuxième transducteurs 11a et 11b à la tension nominale.

Notons que sur les figures 1D et 1E, le capot 18 et ladite au moins butée latérale sont référencés, qui sont conformes à la description qui en est donnée ci-dessus notamment en référence aux figures 1A et 1B.

Notons que la portée des revendications annexées n'exclut pas un microsystème combinant différents ensembles des transducteurs 11, 11a, 11b, 11c et 11d susmentionnés. Ainsi, et à titre d'exemples non limitatifs, le mode de réalisation illustré sur la figure 1D pourrait comprendre, en complément ou en alternative aux transducteurs 11, 11a, 11b, 11c et 11d, au moins un ensemble de premier et deuxième transducteurs 11a et 11b tels qu'illustrés sur la figure 1B ; le mode de réalisation illustré sur la figure 1E pourrait comprendre un ensemble de transducteurs 11a, 11b, 11c et 11d tel qu'illustré sur la figure 1D en complément ou en alternative à au moins un ensemble de premier et deuxième transducteurs 11a et 11b tel qu'illustré sur la figure 1E.

Notons que, quel que soit celui des modes de réalisation du microsystème électromécanique selon l'invention décrits ci-dessus, chaque transducteur électromécanique 11, 11a, 11b, 11c, 11d n'est pas limité à une forme annulaire ou de disque, respectivement, mais peut prendre d'autres formes, et notamment une forme oblongue, ovale, triangulaire, rectangulaire, etc., creuse ou pleine selon le transducteur considéré. Les illustrations des figures 1B à 1E valent en particulier pour une structure à symétrie de rotation ou de révolution des transducteurs électromécaniques. Néanmoins, l'invention n'est pas limitée à de telles structures à symétrie de rotation ou de révolution des transducteurs électromécaniques.

Notamment lorsque le recouvrement partiel de la membrane déformable 12 par les transducteurs électromécaniques est tel qu'illustré sur les figures 1C à 1E et que chaque transducteur électromécanique est un transducteur piézoélectrique comprenant un matériau piézoélectrique à base de PZT, il est intéressant que la partie mobile 111, 111a, 111b, 111c, 111d de chacun des premier et deuxième transducteurs électromécaniques 11, 11a, 11b, 11c, 11d présente une surface au moins 2 fois supérieure à la surface de la zone libre 121 de la membrane déformable 12. La membrane déformable 12 est dès lors configurée de sorte que sa zone libre 121 soit capable de se déformer avec une amplitude d'au moins 50 µm, d'environ 100 µm, voire de plusieurs centaines de microns. De manière générale, la membrane déformable 12 est configurée de sorte que sa zone libre 121 soit capable de se déformer avec une amplitude inférieure à 1 mm. Cette déformation est mesurée selon une direction perpendiculaire au plan dans lequel s'étend principalement la face externe 12e de la membrane 12 au repos. Sans se déchirer et/ou sans usure significative, le microsystème électromécanique 1 permet une amplification hydraulique de l'action et offre ainsi la capacité à satisfaire de nombreuses et diverses applications nécessitant un grand débattement. Dans ce contexte, le microsystème électromécanique 1 selon chacun des deux modes de réalisation décrits ci-dessus peut être défini comme un actionneur à grand débattement ascendant et descendant.

Comme déjà mentionné plus haut, chaque transducteur électromécanique 11, 11a, 11b, 11c, 11d comprend plus particulièrement un élément constituant une poutre 305 et un élément piézoélectrique 302 à base de PZT, ce dernier étant configuré pour induire une déflexion de la poutre 305. L'épaisseur de l'élément piézoélectrique 302 peut être sensiblement égale à 0,5 µm et l'épaisseur de la poutre 305 est de préférence comprise entre quelques microns et plusieurs dizaines de microns, et par exemple sensiblement égale à 5 µm.

L'invention n'est toutefois pas limitée aux différentes valeurs spécifiques données ci-dessus qui peuvent être largement adaptées, en fonction de l'application visée, notamment pour trouver un compromis entre facteur d'étirement et amplitude de déformation attendue de la zone libre 121 de la membrane déformable 12.

Notons que, notamment lorsqu'un des transducteurs électromécaniques est un transducteur piézoélectrique, il peut avantageusement être un transducteur à fonctionnement vibratoire. Sa fréquence de résonance est alors de préférence inférieure à 100 kHz, et encore plus préférentiellement inférieures à 1 kHz. La dynamique vibratoire ainsi obtenue peut permettre d'atteindre des débattements plus grands qu'en fonctionnement statique, notamment en exploitant le phénomène de résonnance afférent ou de diminuer la consommation du microsystème électromécanique pour un débattement donné.

Comme déjà mentionné plus haut, le microsystème électromécanique 1 peut comprendre en outre une ou plusieurs butées latérales 15 supportées par la paroi 131 de la cavité 13. Chaque butée latérale 15 s'étend plus particulièrement à l'opposé de la cavité 13.

Relativement aux butées latérales 15, le pion 122 peut s'étendre, à l'opposé de la cavité 13, au-delà ou en deçà.

Les butées latérales 15 peuvent également être configurées pour permettre le guidage et l'auto-positionnement de l'organe externe 2 sur le microsystème électromécanique 1. Elle contribue encore à limiter, voire à annihiler, le risque d'arrachement de la membrane déformable 12 lors du report de l'organe externe 2 sur le microsystème électromécanique 1. Notons ici que, dépendant de l'étendue de l'organe externe 2, les butées latérales 15 peuvent également jouer le rôle de butée haute limitant le rapprochement de l'organe externe 2 vers le microsystème électromécanique 1. Lorsque la zone libre est configurée pour coopérer avec au moins un organe externe de sorte que sa déformation induise, ou soit induite par, un mouvement de l'organe externe, cette particularité peut également permettre d'induire une désolidarisation du pion 122 et de l'organe externe 2 entre eux en tirant le pion 122 dans une position plus basse que celle possiblement atteinte par l'organe externe 2 du fait que ce dernier bute sur le haut des butées latérales 15. Plus précisément, les butées latérales 15 présentent alors une surface de butée configurée pour stopper le déplacement de l'organe 12. Le microsystème électromécanique 1 est configuré de sorte à ce que, lorsque le déplacement de l'organe 12 est stoppé dans son déplacement, selon un sens donné, par les butées latérales 15, le pion 122 peut poursuivre son déplacement, dans ce même sens. Le pion 122 se désolidarise ainsi de l'organe 12.

Comme illustré sur la figure 1A, le microsystème électromécanique 1 peut comprendre en outre une ou plusieurs butées dites basses 16 supportées par la paroi 132 de la cavité 13 qui est opposée à la paroi 131 formée au moins en partie par la membrane déformable 12 et s'étendant dans la cavité 13 vers la zone libre 121 de la membrane déformable 12. Cette butée basse 16 présente de préférence une forme et des dimensions configurées pour limiter la déformation de la zone libre 121 de la membrane déformable 12 de sorte à protéger la membrane déformable 12, et plus particulièrement sa zone libre 121, d'un éventuel arrachement, notamment lors du report de l'organe externe 2 sur le microsystème électromécanique 1. De manière alternative ou cumulée, la butée basse 16 est conformée de sorte à limiter la surface de contact entre la membrane 12 et la paroi 132 de la cavité 13 opposée à la zone libre 121 de la membrane 12 déformable. Cela permet d'éviter que la membrane 12 n'adhère et ne se colle à cette paroi 132.

Un mode de réalisation de l'invention plus spécifique que celui décrit ci-dessus en référence aux figures 1A et 1B est illustré sur la figure 2 sur laquelle les mêmes références que sur les figures 1A et 1B référencient les mêmes objets.

On y observe tout d'abord que chaque transducteur électromécanique 11, 11a, 11b illustré comprend une poutre 305 et un matériau piézoélectrique 302 configuré pour déformer la poutre 305 lorsqu'il est mis sous tension électrique. Plus particulièrement, les premier et deuxième transducteurs 11a et 11b partage une même poutre 305, leurs éléments piézoélectriques 302 étant agencés en regard de zones différentes de la poutre 305.

On remarque également que les éléments piézoélectriques 302 des transducteurs 11, 11a et 11b se situent tous d'un même côté de la poutre 305 ou équivalemment de la fibre neutre de ces transducteurs. Comme annoncé plus haut, ce mode de réalisation conforme, pour ce qui est de son principe, à celui illustré sur la figure 1A, est d'une fabrication avantageusement simple relativement à la fabrication d'un microsystème dans lequel l'élément piézoélectrique 302 du troisième transducteur 11 se situeraient de l'autre côté de la poutre 305 relativement aux éléments piézoélectriques 302 des premier et deuxième transducteurs 11a et 11b.

L'on comprend que l'élément piézoélectrique 302 du premier transducteur 11a est propre à déformer principalement la poutre 305 au niveau d'une zone centrale de la zone 123ab dans laquelle s'étendent les éléments piézoélectriques des premier et deuxième transducteurs 11a et 11b, tandis que l'élément piézoélectrique 302 du deuxième transducteur 11b est propre à déformer principalement la poutre 305 au niveau d'une zone périphérique à ladite zone centrale.

On observe en outre, sur la figure 2, que la partie mobile 111, 111a, 111b de chaque transducteur électromécanique 11, 11a, 11b peut être sensiblement définie par l'étendue de l'élément piézoélectrique 302 relativement à l'étendue de la poutre 305.

Sur la figure 2, on observe également des ouvertures d'accès pour une connexion électrique des électrodes. Ces ouvertures forment dans ces exemples des via 17. Dans cet exemple, les vias 17 traversent toute l'épaisseur de la poutre 305. L'épaisseur e₃₀₅ de la poutre 305 est mesurée selon une direction perpendiculaire au plan dans lequel s'étend principalement les faces 12e et 12i de la membrane 12. L'épaisseur e₃₀₅ est référencée en figure 2.

La figure 2 illustre plus particulièrement, que ne le font les figures 1A et 1B, le premier mode de réalisation de l'invention déjà discuté plus haut. Notamment, la figure 2 montre le premier mode de réalisation de l'invention tel qu'obtenu par des étapes de dépôt et de gravure pouvant être qualifiées comme ordinaires dans le domaine de la microélectronique (et ce peut être également le cas de chacun des autres modes de réalisation de l'invention). Plus particulièrement, le microsystème électromécanique 1 selon le premier mode de réalisation illustré sur la figure 2 a été obtenu par un procédé de fabrication comprenant au moins :
- une étape de formation de ce qui est destiné à constituer une portion au moins de chaque transducteur électromécanique 11, 11a, 11b sur un substrat, puis
- une étape de dépôt de la membrane déformable 12, puis
- une étape de formation d'une cavité 13 ouverte sur la membrane déformable 12, puis
- une étape de remplissage avec le milieu déformable et de fermeture de la cavité 13, et
- une étape de gravure du substrat pour former la face avant du microsystème électromécanique 1 illustré sur la figure 2.

Notons également que chaque capot 18 et chaque butée latérale 15 discutés plus haut sont aussi formés par la mise en œuvre des étapes technologiques dont le résultat est illustré sur la figure 2. Chaque capot 18 et chaque butée latérale 15 prennent chacun la forme d'un empilement structuré s'étendant directement depuis la membrane déformable 12 à l'opposé de la cavité 13 en présentant successivement le matériau d'une couche isolante, le matériau constituant la poutre 305 et le matériau d'une autre couche isolante.

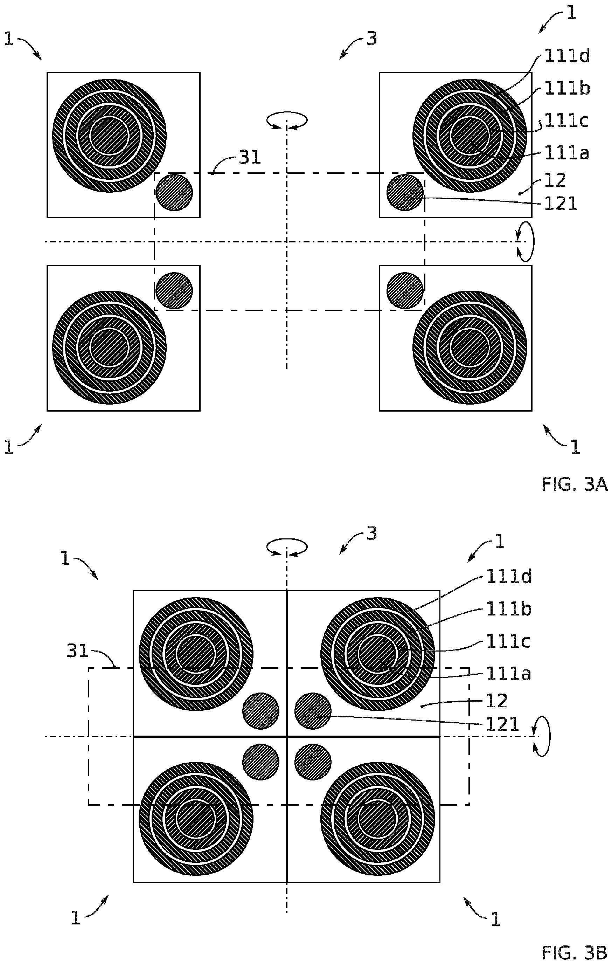

Un autre aspect de l'invention concerne un système opto-électro-mécanique 3 tel qu'illustré sur les figures 3A, 3B, 4A et 4B. Il peut s'agir d'un microsystème opto-électro-mécanique 3. Chacun des microsystèmes opto-électro-mécaniques 3 illustrés sur ces figures comprennent au moins un microsystème électromécanique 1 tel que décrit ci-dessus et au moins un microsystème optique 31. Ledit au moins un microsystème électromécanique 1 est de préférence monté sur un support 32 du microsystème opto-électro-mécanique 3. Ledit au moins un microsystème optique 31 peut comprendre un micro-miroir à base de silicium, dont la surface est le cas échéant surmontée d'au moins un miroir. Il peut être monté directement sur ledit au moins un microsystème électromécanique 1 ou y être monté par l'intermédiaire d'un cadre 33. Il peut présenter des dimensions sensiblement égales à 2 mm x 5 mm et/ou, au maximum, une épaisseur d'environ 700 µm. Les microsystèmes opto-électro-mécaniques 3 tels qu'illustrés comprennent chacun quatre microsystèmes électromécaniques 1 présentant chacun une zone libre 121 agencée en vis-à-vis d'une partie d'un même microsystème optique 31, cette partie lui étant propre et étant de préférence un coin dudit microsystème optique 31 ou de son centre. On obtient ainsi un microsystème opto-électro-mécanique 3 bénéficiant d'une large capacité d'adaptation de son orientation optique.

Notons également que du fait de la possibilité qu'offre chaque microsystème électromécanique 1 selon l'invention d'agir sur le microsystème optique 31 en le déplaçant pas à pas vers le haut et/ou vers le bas, les angles d'inclinaison du microsystème optique 31 atteignables sont ainsi avantageusement d'une amplitude augmentée, relativement à des microsystèmes électromécaniques ne permettant d'agir pas à pas. Un meilleur contrôle à chaque instant et une meilleure reproductibilité de l'angle d'inclinaison du microsystème optique 31 sont atteints puisque chaque angle d'inclinaison potentiellement atteint appartient à un ensemble prédéterminé d'angles d'inclinaison, du fait du fonctionnement potentiellement binaire des transducteurs mis en œuvre.

Notons en outre qu'il peut être avantageux, dans le cadre de l'intégration d'un microsystème électromécanique 1 selon le premier aspect invention à un microsystème opto-électro-mécanique 3 selon le deuxième aspect de l'invention, que le microsystème électromécanique 1 utilisé soit choisi parmi ceux décrits plus haut (et envisagés plus bas) ne comprenant pas de troisième transducteur 11. En effet, par exemple du fait du décentrage de la zone libre 121 de la membrane déformable 12 relativement à la zone 123ab sur laquelle s'étendent les premier et deuxième transducteurs électromécaniques 11a et 11b, il est alors possible d'agencer les zones libres 121 des quatre microsystèmes électromécaniques 1 au plus près des coins ou du centre du microsystème optique 31, et en particulier potentiellement plus près que ne le permettraient des microsystèmes électromécaniques dans chacun desquels la zone libre 121 de la membrane déformable 12 serait centrée sur la zone 123 d'un troisième transducteur électromécanique 11 tel qu'illustré schématiquement sur la figure 1A. Les angles d'inclinaison du microsystème optique 31 atteignables sont ainsi avantageusement d'une amplitude augmentée.

L'invention n'est pas limitée aux modes de réalisation précédemment décrits et s'étend à tous les modes de réalisation couverts par les revendications.

Notamment, les modes de réalisation décrits plus haut comprennent pour la plupart au moins trois transducteurs électromécaniques. Cependant, le microsystème 1 selon le premier aspect de l'invention peut ne comprendre que deux transducteurs électromécaniques.

Une première représentation schématique d'un exemple de tel microsystème 1 vient en considérant, sur la figure 1A, que les premier et deuxième transducteurs ne forment qu'un seul est même transducteur configuré pour se mouvoir, lorsqu'il est sollicité, dans le même sens que le transducteur 11 (ce dernier pouvant être configuré pour se mouvoir dans l'un ou l'autre des deux sens).

Une deuxième représentation schématique d'un exemple de microsystème 1 selon le premier aspect de l'invention comprenant deux transducteurs électromécaniques vient en considérant, sur la figure 1A, que seuls les deux transducteurs 11a et 11b sont prévus, et que le transducteur 11 est retiré. Il faut alors que les deux transducteurs restants 11a et 11b soient configurés pour se mouvoir dans un même sens. Soit ils ne sont pas constitués à base de PZT, et peuvent se mouvoir dans n'importe lequel des deux sens ; soit ils sont constitués à base de PZT, et, les transducteurs électromécaniques 11a et 11b s'inscrivant étroitement dans une zone circulaire de rayon déterminé appelé « rayon total » et noté Rₜₒₜ, ladite zone circulaire étant composée de deux parties, une première partie prenant la forme d'un disque centré sur ladite zone circulaire et une seconde partie prenant la forme d'un anneau s'étendant autour de la première partie, le premier transducteur électromécanique 11a ne s'inscrit pas entièrement dans la première partie de la zone circulaire, mais en dépasse, ou le deuxième transducteur électromécanique 11b ne s'inscrit pas entièrement dans la seconde partie de la zone circulaire, mais en dépasse en s'étendant sur la première partie.

Une troisième représentation schématique d'un exemple de microsystème 1 selon le premier aspect de l'invention comprenant deux transducteurs électromécaniques vient en considérant, sur la figure 1E, que seuls deux transducteurs 11a présentant chacun une partie mobile 111a sont prévus, les deux autres transducteurs 11a et les quatre transducteurs 11b étant retirés et les deux transducteurs 11a restants étant configurés pour se mouvoir dans un même sens lorsqu'ils sont sollicités (ces derniers pouvant être configurés pour se mouvoir dans l'un ou l'autre des deux sens).

Par ailleurs, d'autres applications que celles décrites ci-dessus sont envisageables. Par exemple, le microsystème électromécanique 1 peut être agencé dans une micropompe, voire dans un système à tableau de micropompes, ou dans un système haptique.

## Revendications

1. Microsystème électromécanique (1) comprenant :
- au moins deux transducteurs électromécaniques (11, 11a, 11b) comprenant chacun une partie mobile (111, 111a, 111b) entre une position d'équilibre, hors sollicitation, et une position hors équilibre, sous sollicitation,
- au moins une membrane déformable (12),
- une cavité (13) déformable, délimitée par des parois (131, 132, 133), au moins une partie de la membrane déformable (12) formant au moins une partie d'une première paroi (131) prises parmi lesdites parois (131, 132, 133) de la cavité (13), la cavité (13) contenant hermétiquement un milieu déformable (14) conservant un volume sensiblement constant sous l'action d'un changement de pression externe exercée sur le milieu déformable (14) à travers l'une paroi des parois (131, 132, 133) de la cavité (13),
dans lequel la partie mobile (111, 111a, 111b) de chaque transducteur électromécanique (11, 11a, 11b) est configurée de sorte que son mouvement soit fonction dudit changement de pression externe, ou inversement que son mouvement induise un changement de pression externe, et dans lequel ladite au moins une partie de la membrane déformable (12) présente au moins une zone libre (121) de se déformer, en fonction dudit changement de pression externe,
le microsystème électromécanique (1) étant en outre tel que :
les parties mobiles (111, 111a, 111b) desdits au moins deux transducteurs électromécaniques (11, 11a, 11b) sont configurées de sorte que :
- leur sollicitation ou une augmentation de pression externe induise leur mouvement vers l'extérieur de la cavité (13), ou
- leur sollicitation ou une diminution de pression externe induise leur mouvement vers l'intérieur de la cavité (13),
dans lequel ladite au moins une zone libre (121) coopère avec au moins un organe externe (2) de sorte que sa déformation induise, ou soit induite par, un mouvement de l'organe externe (2), et
dans lequel la zone libre (121) de la membrane déformable (12) coopère avec l'organe externe (2) via un pion (122) fixé sur ladite zone libre (121), de préférence au contact de ladite zone libre (121).

2. Microsystème électromécanique (1) selon la revendication précédente, comprenant au moins trois transducteurs électromécaniques (11, 11a, 11b) comprenant chacun une partie mobile (111, 111a, 111b) entre une position d'équilibre, hors sollicitation, et une position hors équilibre, sous sollicitation,
la partie mobile (111, 111a, 111b) de chaque transducteur électromécanique (11, 11a, 11b) étant configurée de sorte que son mouvement soit fonction dudit changement de pression externe, ou inversement que son mouvement induise un changement de pression externe,
dans lequel :
- la partie mobile (111a) d'un premier transducteur électromécanique (11a) est configurée de sorte que sa sollicitation ou une augmentation de pression externe induise son mouvement vers l'extérieur de la cavité (13),
- la partie mobile (111b) d'un deuxième transducteur électromécanique (11b) est configurée de sorte que sa sollicitation ou une diminution de pression externe induise son mouvement vers l'intérieur de la cavité (13), et
- la partie mobile (111) d'un troisième transducteur électromécanique (11) est configurée de sorte que sa sollicitation ou une augmentation de pression externe induise son mouvement vers l'extérieur et/ou vers l'intérieur de la cavité (13).

3. Microsystème électromécanique (1) selon l'une quelconque des revendications précédentes, dans lequel deux desdits au moins deux transducteurs électromécaniques (11a et 11b) s'étendent, sur au moins une des parois (131, 132, 133) de la cavité (13), à distance de la zone libre (121) de la membrane déformable (12).

4. Microsystème électromécanique (1) selon l'une quelconque des revendications précédentes, dans lequel le premier transducteur électromécanique (11a) a la forme d'un disque de rayon R1 et le deuxième transducteur électromécanique (11b) a la forme d'un anneau s'étendant dans une zone d'étendue radiale R2 autour du disque formé par le premier transducteur électromécanique (11a).

5. Microsystème électromécanique (1) selon l'une quelconque des revendications précédentes, dans lequel l'étendue radiale de l'anneau formé par le deuxième transducteur électromécanique (11b) est sensiblement deux fois plus petite que le rayon R1 du disque formé par le premier transducteur électromécanique (11a).

6. Microsystème électromécanique (1) selon la revendication précédente, dans lequel, avec le microsystème (1) comprenant un troisième transducteur électromécanique et avec les premier deuxième transducteurs électromécaniques (11a, 11b) s'inscrivant étroitement dans une zone circulaire de rayon déterminé appelé « rayon total » et noté Rₜₒₜ, ladite zone circulaire étant composée de deux parties, une première partie prenant la forme d'un disque centré sur ladite zone circulaire et une seconde partie prenant la forme d'un anneau s'étendant autour de la première partie, ledit au moins un premier transducteur électromécanique (11a) s'inscrit dans la première partie de la zone circulaire et ledit au moins un deuxième transducteur électromécanique (11b) s'inscrit dans la seconde partie de la zone circulaire, la première partie de la zone circulaire présentant un rayon R_{2/3} sensiblement égale aux deux tiers du rayon total et la seconde partie de la zone circulaire présentant une étendue E_{1/3} sensiblement égale au tiers du rayon total.

7. Microsystème électromécanique (1) selon l'une quelconque des revendications 2 à 6, dans lequel le troisième transducteur électromécanique (11) s'étend sur au moins une des parois (131, 132, 133) de la cavité (13) et sur une zone annulaire autour de la zone libre (121) de la membrane déformable (12).

8. Microsystème électromécanique (1) selon l'une quelconque des revendications 2 à 7, comprenant, en alternative ou en complément au troisième transducteur électromécanique (11), au moins un autre transducteur électromécanique (11c, 11d) ayant la forme d'un anneau et s'étendant autour du premier transducteur électromécanique (11a) ayant une forme de disque ou autour du deuxième transducteur électromécanique (11b) ayant une forme d'anneau, la partie mobile (111c, 111d) dudit au moins un autre transducteur électromécanique (11c, 11d), lorsque ce dernier comprend un élément piézoélectrique à base de PZT, se déforme sous sollicitation, dans des sens opposés entre eux, selon qu'il s'inscrit :
- dans une première partie d'une zone circulaire dans laquelle s'inscrivent étroitement les premier et deuxième transducteurs électromécaniques (11a, 11b) et ledit au moins un autre transducteur électromécanique (11c, 11d), cette première partie présentant un rayon R2/3 sensiblement égale aux deux tiers du rayon de ladite zone circulaire, ou
- dans une seconde partie de la zone circulaire, cette seconde partie présentant une étendue E1/3 sensiblement égale au tiers du rayon de la zone circulaire.

9. Microsystème électromécanique (1) selon l'une quelconque des revendications 2 à 7, comprenant, en alternative ou en complément au troisième transducteur électromécanique (11) et/ou audit au moins un autre transducteur électromécanique (11c, 11d), au moins deux autres transducteurs électromécaniques s'étendant, sur au moins une des parois de la cavité (13), à distance de la zone libre (121) de la membrane déformable (12) et des premier et deuxième transducteurs électromécaniques (11a et 11b) et n'étant agencé ni autour de la zone libre (121) de la membrane déformable (12), ni autour des premier et deuxième transducteurs électromécaniques (11a et 11b), et dans lequel un premier desdits au moins deux autres transducteurs électromécaniques a la forme d'un disque et un deuxième desdits au moins deux autres transducteurs électromécaniques a la forme d'un anneau s'étendant autour du disque formé par le premier desdits au moins deux autres transducteurs électromécaniques.

10. Microsystème électromécanique (1) selon l'une quelconque des revendications précédentes, dans lequel la membrane déformable (12) présente plusieurs zones libres (121a, 121b, 121c, 121d et 121e), présentant le cas échéant des formes et/ou des dimensions différentes entre elles.

11. Microsystème électromécanique (1) selon l'une quelconque des revendications précédentes, dans lequel le pion (122) est fixé au centre de la zone libre (121) de la membrane déformable (12).

12. Microsystème électromécanique (1) selon l'une quelconque des revendications précédentes, dans lequel la partie mobile (111, 111a, 111b) d'au moins l'un, voire de chacun, desdits au moins deux transducteurs électromécaniques (11, 11a, 11b) présente une surface au moins deux fois supérieure à une surface de ladite au moins une zone libre (121) de la membrane déformable (12).

13. Microsystème électromécanique (1) selon l'une quelconque des revendications précédentes, dans lequel au moins l'un, voire chacun, desdits au moins deux transducteurs électromécaniques (11, 11a et 11b) est un transducteur à fonctionnement vibratoire à au moins une fréquence de résonance, ladite au moins une fréquence résonance étant de préférence inférieure à 100 kHz, et encore plus préférentiellement inférieure à 1 kHz.

14. Système opto-électro-mécanique (3) comprenant au moins un microsystème électromécanique (1) selon l'une quelconque des revendications précédentes et au moins un microsystème optique (31), dans lequel ledit au moins un microsystème optique (31) comprend au moins un miroir, de préférence à base de silicium, le système opto-électro-mécanique (3) étant configuré de sorte à ce que chaque mouvement de la partie mobile (111, 111a, 111b) de chaque transducteur électromécanique (11, 11a, 11b) provoque un déplacement de l'au moins un miroir.

15. Procédé de fabrication d'un microsystème électromécanique (1) selon l'une quelconque des revendications 1 à 13, comprenant :
- une étape de formation, sur un substrat (200), d'une portion au moins de chacun desdits au moins deux transducteurs électromécaniques (11, 11a, 11b), puis
- une étape de dépôt de la membrane déformable (12), puis
- une étape de formation d'au moins une cavité (13) ouverte sur la membrane déformable (12), puis
- une étape de remplissage avec le milieu déformable (14) et de fermeture de la cavité (12), et
- une étape de gravure du substrat (200) pour former une face avant (FAV) du microsystème électromécanique (1).
